# EUROPÄISCHE PATENTSCHRIFT

(11) **EP 1 068 630 B1**
(45) Veröffentlichungstag und Bekanntmachung des Hinweises auf die Patenterteilung: **20.07.2005**
(21) Anmeldenummer: 99914503.0
(22) Anmeldetag: 10.03.1999
(51) Int. Cl.: H01J 37/28, H01J 37/244

(54) **RASTERELEKTRONENMIKROSKOP**
SCANNING ELECTRON MICROSCOPE
MICROSCOPE ELECTRONIQUE A BALAYAGE

(30) Priorität: 10.03.1998 DE 19810301; 01.10.1998 DE 19845329
(43) Veröffentlichungstag der Anmeldung: 17.01.2001
(73) Patentinhaber: Essers, Erik, 76131 Karlsruhe (DE)
(72) Erfinder: Essers, Erik, 76131 Karlsruhe (DE)
(74) Vertreter: Hertz, Oliver, Dr.
(86) Internationale Anmeldenummer: PCT/EP1999/001544
(87) Internationale Veröffentlichungsnummer: WO 1999/046797

(56) Entgegenhaltungen:
- EP-A- 0 817 235
- WO-A-97/07526
- US-A- 5 362 964
- US-A- 5 677 531

## Beschreibung

Die Erfindung betrifft ein Rasterelektronenmikroskop (REM), insbesondere ein unter etwas erhöhtem Druck arbeitendes Rasterelektronenmikroskop oder die Umrüstung eines unter Vakuum betriebenen Rasterelektronenmikroskops für den Betrieb mit Gas in der Probenkammer, und bezieht sich insbesondere auf eine verbesserte Detektionseffizienz eines derartigen Mikroskops (d.h. auf die Verbesserung des Signal-zu-Rausch-Verhältnis der damit aufgenommenen Bilder), insbesondere beim Betrieb mit niedriger Primäfenergie.

Bei einem Rasterelektronenmikroskop, das unter etwas erhöhtem Druck arbeitet (Druck-REM), ist in der Probenkammer üblicherweise ein maximaler Betriebsdruck von einigen Hektopascal bis einigen Kilopascal zugelassen. Die Primärelektronen haben bei diesem Druck nur eine kurze mittlere freie Weglänge. Deshalb wird die Mikroskopsäule zur Probenkammer hin durch eine Druckstufenblende (oder druckbegrenzende Blende) abgeschlossen, durch die der Primärelektronenstrahl in die Probenkammer eintritt. Oberhalb dieser Druckstufenblende ist der Druck um mehrere Zehnerpotenzen verringert.

Mit einer Szintillator-Lichtleiter-Kombination, die zwischen der Probe und der Druckstufenblende angeordnet ist, können die von der Probe emittierten Rückstreuelektronen detektiert werden. Eine demgegenüber verbesserte Ortsauflösung erhält man bei der Verwendung der von der Probe emittierten Sekundärelektronen, die mit Hilfe einer Kollektorelektrode detektiert werden können (WO 88/09564 A1). Dabei ist üblicherweise die Unterseite der Druckstufenblende als Kollektorelektrode ausgebildet oder eine separate Kollektorelektrode unterhalb der Druckstufenblende angeordnet.

Bei anderen Rasterelektronenmikroskopen, die unter etwas erhöhtem Druck arbeiten, findet die Detektion des Rückstrenelektronensignals durch die Öffnung der Druckstufenblende hindurch in einer Art Vorkammer statt, die nach oben zur Objektivlinse hin durch eine weitere Druckstufenblende abgeschlossen ist. Als Detektor für die von dem Rückstrenelektronen im Gas erzeugten Elektronen wird auch hier eine Kollektorelektrode verwendet (WO 90/04261 A1). Eine ähnliche Gestaltung wurde zwar erprobt (G. D. Danilatos,,,Design and Construction of an Environmental SEM; Part 4",Scanning Vol.12 (1990), S. 23), hat sich jedoch in der praktischen Anwendung nicht durchgesetzt.

Detektorsysteme mit Kollektorelektroden haben wegen des Rauschens bei der nachfolgenden elektronischen Verstärkung eine schlechte Nachweisempfindlichkeit und erfordern deshalb eine Vorverstärkung des Sekundärelektronensignals vor dem Erreichen der Kollektorelektrode, Diese Vorverstärkung erfolgt mit Hilfe eines elektrischen Feldes zwischen der Probe und der Kollektorelektrode, durch das die von der Probe emittierten Sekundärelektronen beschleunigt werden, so daß sie Gasmoleküle ionisieren können. Nach dem Stoß mit den Gasmolekülen werden die dabei im Gas erzeugten Sekundärelektronen und die bereits vorher vorhandenen Sekundärelektronen wieder durch das elektrische Feld beschleunigt und erzeugen weitere Sekundärelektronen im Gas. Auf diese Weise wird durch die von der Probe emittierten Sekundärelektronen eine Sekundärelektronenkaskade ausgelöst, die schließlich die Kollektorelektrode erreicht. Auch bei Verwendung eines Lichtleiters mit nachgeschaltetem Photomultiplier als Gasszintillationsdetektor wird eine Sekundärelektronenkaskade als Vorverstärkung verwendet.

Trotz dieser Kaskaden-Vorverstärkung ist in beiden Fällen das Signal-zu-Rausch-Verhältnis der bei etwas erhöhtem Druck aufgenommenen Bilder, bei gleicher Strahlstromstärke wesentlich schlechter als bei den Bildern, die ohne erhöhten Druck mit konventionellen Sekundärelektronendetektoren aufgenommen werden. Insbesondere für die Untersuchung empfindlicher Proben (beispielsweise Halbleiterbauelemente, Kunststoffe, biologische und medizinische Proben) stellt deshalb die Verbesserung der Detektionseffizienz und die Verringerung des Detektor-Rauschens der Druck-REMs eine wichtige Aufgabe dar.

Bei der Untersuchung empfindlicher Proben ist weiterhin die Verwendung einer niedrigen Primärenergie vorteilhaft, um der Probe weniger Energie zuzuführen und um die Schädigung der Probe durch den Elektronenstrahl auf eine dünne Oberflächenschicht zu begrenzen. Die bisher bekannten Druck-REMs benötigen für ihre Kollektorelektrode eine Sekundärelektronenkaskade im Gas und sind deshalb für den Betrieb mit niedriger Primärenergie (von beispielsweise 1 keV), insbesondere bei der Beobachtung feuchter Proben, ungeeignet. Für den Betrieb mit niedriger Primärenergie sind nämlich eine möglichst kurze Gasstrecke zwischen der Probe und der darüberliegenden Druckstufenblende, sowie ein möglichst geringer Druck oberhalb der Druckstufenblende erforderlich, da mit abnehmender Primärenergie auch die mittlere freie Weglänge der Primärelektronen im Gas abnimmt. Unter diesen Bedingungen ist jedoch keine befriedigende Kaskaden-Vorverstärkung mehr möglich, so daß die bisher bekannten Druck-REMs beim Betrieb mit Gas in der Probenkammer zur Beobachtung feuchter Proben erst ab einer Primärenergie von 3 keV verwendet werden können. Aber auch bei 3 keV wird durch den hohen Anteil an gestreuten Primärelektronen ein Signal-Untergrund erzeugt, der dazu führt, daß die Bilder ein noch wesentlich schlechteres Signal-zu-Rausch-Verhältnis aufweisen als bei hoher Primärenergie. Dasselbe gilt auch für den Betrieb mit niedriger Primärenergie (von beispielsweise 1,5 keV), der bei den bisher bekannten Druck-REMs bei einem Druck bis zu etwa 1,5 hPa zu Zwecken der Aufladungsbekämpfung verwendet wird.

Durch die schlechte Detektionseffizienz und bei der Verwendung einer Kollektorelektrode auch durch die Zeitkonstante des Operationsverstärkers sind die heutigen Druck-REMs außerdem für geringe Strahlstromstärken nicht gut geeignet. Insbesondere bei der Untersuchung feuchter Proben bei hoher Vergrößerung wären eine geringere Strahlstromstärke und eine geringere Primärenergie jedoch wichtig, um eine lokale Erwärmung und das damit verbundene Austrocknen der betrachteten Probenstelle zu vermeiden.

Weiterhin besteht der Bedarf nach einem Druck-REM mit gutem Signal-zu-Rausch-Verhältnis, das auch für niedrige Primärenergie geeignet ist, auch, um feine Oberflächenstrukturen leichter Elemente besser wiedergeben zu können und den Kanteneffekt zu vermeiden.

Die Aufladungsbekämpfung beim Betrieb mit niedriger Primärenergie stellt eine weitere wichtige Aufgabe dar, die von den heutigen Druck-REMs wegen des dabei erhaltenen schlechten Signal-zu-Rausch-Verhältnis nicht zufriedenstellend gelöst wird. Anwendungsmöglichkeited für entsprechende Druck-REMs bestehen beispielsweise in der Abbildung empfindlicher Kunststoffe, in der Elektronenstrahllithographie und bei Metrologiegeräten, wie sie beispielsweise in der Halbleiterindustrie zur automatisierten Überwachung in der Produktion verwendet werden. Statt dessen wird heute in anderen Metrologiegeräten der Einfluß der Aufladungen verringert, indem Rückstreuelektronen für die Abbildung verwendet werden.

Der Erfindung liegt die Aufgabe zugrunde, ein verbessertes, unter etwas erhöhtem Druck arbeitendes REM (im folgenden: Druck-Rasterelektronenmikroskop oder Druck-REM) anzugeben, das die genannten Nachteile herkömmlicher Druck-REMs nicht aufweist, und insbesondere die Detektionseffizienz von Druck-REMs, bei denen die Detektion der von der Probe emittierten Sekundärelektronen durch die Druckstufenblende stattfindet, durch die die Mikroskopsäule zur Probenkammer hin abgeschlossen ist (bzw. das Signal-zu-Rausch-Verhältnis der damit aufgenommenen Bilder), insbesondere beim Betrieb mit niedriger Primärenergie zu verbessern.

Diese Aufgabe wird durch ein REM und ein Verfahren mit den Merkmalen gemäß Patentanspruch 1 oder 22 gelöst. Vorteilhafte Ausführungsformen der Erfindung ergeben sich aus den abhängigen Ansprüchen.

Der Erfindung liegt allgemein die Idee zugrunde, ein Rasterelektronenmikroskop mit den Merkmalen gemäß dem Oberbegriff von Patentanspruch 1 so weiterzubilden, daß als Detektor ein hochempfindlicher, gegenüber der Probe positiv vorgespannter Detektor verwendet wird.

Erfindungsgemäß wird die Aufgabe insbesondere gemäß einem ersten Gesichtspunkt ferner insbesondere dadurch gelöst, daß oberhalb der Druckstufenblende ein oder mehrere Elektrodenelemente (massive Elektroden oder dünne Elektrodenschichten) angeordnet sind, die gegenüber der Druckstufenblende auf positivem Potential liegen, wobei als Detektor für die in der Probe und im Gas erzeugten Sekundärelektronen keine Kollektorelektrode, sondern ein oder mehrere Detektoren mit höherer Nachweisempfmdlichkeit verwendet werden.

Der Vorteil der Erfindung besteht insbesondere darin, daß - unabhängig von dem Vorhandensein einer Sekundärelektronenkaskade - eine hohe Detektionseffizienz für die von der Probe emittierten Sekundärelektronen und ein geringes Rauschen des Detektorsystems erzielt werden. Bei den erfindungsgemäßen Druck-REMs kann die Länge der Wegstrecke, die die Primärelektronen durch das Gas zurücklegen müssen, sehr klein (< 300 µm) gemacht werden, indem ein kurzer Abstand zwischen der Probe und der Druckstufenblende verwendet wird und oberhalb der Druckstufenblende stark abgepumpt wird. Die bisher bekannten Druck-REMs sind für solche kurzen Wegstrecken (< 300 µm) der Primärelektronen durch das Gas hingegen prinzipiell ungeeignet, weil sich dabei weder unterhalb noch oberhalb der Druckstufenblende eine ausreichende Sekundärelektronenkaskade ausbilden kann.

Mit der guten Eignung für eine kurze Wegstrecke der Primärelektronen durch das Gas werden durch die erfindungsgemäßen Druck-REMs insbesondere zwei wichtige neue Anwendungsgebiete für Druck-REMs erschlossen und die Eigenschaften bereits bekannter Anwendungen werden verbessert.

Als neues Anwendungsgebiet wird erstens die Rasterelektronenmikroskopie bei geringer Primärenergie (beispielsweise 1 keV und weniger) mit Gas in der Probenkammer (beispielsweise Wasserdampf bei einem Druck von 10 hPa) problemlos möglich. Wegen der hohen Detektionseffizienz und des geringen Rauschens des Detektorsystems ist dabei nur eine geringe Strahlstromstärke erforderlich. Hiermit können feuchte Proben bei höheren Vergrößerungen als bisher ohne Austrocknen der betrachteten Probenstelle beobachtet werden. Außerdem stellt auch die Aufladungsbekämpfung beim Betrieb mit niedriger Primärenergie und guter Detektionseffizienz eine wichtige Verbesserung der bisherigen Möglichkeiten dar.

Zweitens wird durch die erfindungsgemäßen Druck-REMs bei hoher Primärenergie (> 15 keV)Rasterelektronenmikroskopie mit Sekundärelektronen bei ungewöhnlich hohem Druck (> 100 hPa) möglich. Bei Verwendung einer Druckstufenblende mit sehr kleinem Bohrungsdurchmesser (von beispielsweise 20 µm) ist, bei extrem kleinen Abständen (< 50 µm) zwischen der Probe und der Druckstufenblende, sogar der Betrieb bei Umgebungsdruck (1013 hPa) möglich.

Außerdem kann insbesondere bei niedriger Primärenergie mit Hilfe bestimmter Gase (beispielsweise Sauerstoff oder sauerstoffhaltige Verbindungen) der Probenkontamination entgegengewirkt werden, die bei niedriger Primärenergie ein Problem in der Rasterelektronenmikroskopie darstellt.(Eine wirkungsvolle Reinigung der Probe vor der Untersuchung in REMs kann erreicht werden, wenn in die Schleuse ein Hochfrequenzplasmareinigungsgerät integriert wird.)

Eine weitere Verbesserung der Detektionseffizienz von Druck-REMs, bei denen die Detektion der Sekundärelektronen durch eine oder mehrere Druckstufenblenden hindurch stattfindet, erreicht man gemäß einem zweiten Gesichtspunkt der Erfindung insbesondere durch die Vergrößerung des Anteils der Sekundärelektronen, die durch die Druckstufenblenden hindurch gelangen. Dieser Anteil kann vergrößert werden, indem mindestens eine Druckstufenblende schichtweise aufgebaut wird aus zwei oder mehr leitfähigen Schichten mit dazwischenliegenden, schlecht leitenden oder isolierenden Schichten, so daß die Unterseite und die Oberseite der Druckstufenblende auf verschiedene Potentiale gelegt werden können. Dadurch wird in der Bohrung der Druckstufenblende ein elektrisches Feld erzeugt, das den Transport der Sekundärelektronen verbessert.

Die oben genannten ersten und zweiten Gesichtspunkte der Erfindung können einzeln oder gemeinsam implementiert werden, um die oben aufgeführte Aufgabe zu lösen. In beiden Fällen wird die Beschleunigung von Sekundärelektronen aus einem probennahen Bereich mit erhöhtem Druck hin zum Detektor in einen probenfemen Bereich mit reduziertem Druck (Vakuum) unterstützt.

Bei den üblichen Sekundärelektronendetektoren mit hoher Nachweisempfindlichkeit löst jedes einzelne Sekundärelektron eine große Anzahl Photonen, Elektronen oder Elektron-Loch-Paare aus, die dann detektiert werden. Hierzu ist es erforderlich, daß den Sekundärelektronen vor dem Erreichen des Detektors oder (bei Channelplate und Channeltron) entlang der Detektoroberfläche Energie zugeführt wird. Zu diesem Zweck muß zwischen der Probe und dem Detektor bzw. (bei Channelplate und Channeltron) entlang der Detektoroberfläche eine große elektrische Spannung angelegt werden.

Eine bevorzugte Ausführungsform der Erfindung besteht deshalb darin, daß die gesamte Detektoroberfläche oder Teile der Detektoroberfläche auf einem Potential liegen, das gegenüber dem Potential der Probe um mehr als 500 V, vorzugsweise 1000 V positiv ist. Die Verwendung solcher Detektoren in der Probenkammer eines herkömmlichen Druck-REMs würde zu Überschlägen führen.

Eine bevorzugte Ausführungsform der Erfindung besteht darin, daß das Druck-REM eine kombinierte elektrostatische und magnetische Objektivlinse besitzt. Gegenüber der einfacher herstellbaren rein elektrostatischen Objektivlinse (DE 3703029 A1) ist dies insbesondere dann von Vorteil, wenn das so ausgestaltete Druck-REM auch beiden üblichen Primärenergien oberhalb von 3 keV eingesetzt werden soll. Verglichen mit einer rein magnetischen Objektivlinse, ist eine kombinierte elektrostatische und magnetische Objektivlinse insbesondere dann von Vorteil, wenn die Sekundärelektronen durch ein elektrisches Feld auf die Öffnung einer Druckstufenblende fokussiert werden sollen. Insbesondere für die Untersuchung nichtmagnetischer Proben ergeben Ausführungsformen mit einer magnetischen Einpollinse (beispielsweise entsprechend den Objektivlinsen in EP 0790634 A1, DE 4236273 A1, EP 0767482A2 und EP 0817235 A1) eine besonders gute Auflösung und eine besonders gute Detektionseffizienz als wichtige Vorteile.

Die verbesserte Detektionseffizienz kommt durch eine Vergrößerung des Anteils der in der Probe und im Gas erzeugten Sekundärelektronen zustande, die durch die Druckstufenblenden hindurch zum Detektor gelangen. Bei Verwendung einer magnetischen Einpollinse wird dieser Anteil vergrößert, weil die Sekundärelektronen sich auf Spiralbahnen um die magnetischen Feldlinien bewegen, die durch die Öffnungen der Druckstufenblenden hindurchgehen. Im Gas der Probenkammer werden die Sekundärelektronen zwar durch Stöße auf neue Spiralbahnen um benachbarte Feldlinien gebracht, die bei ausreichender magnetischer Feldstärke meistens jedoch ebenfalls durch die Öffnungen der Druckstufenblenden hindurchgehen.

Die Realisierung der Erfindung ist nicht auf Druck-REMs beschränkt, sondern kann durch Umrüstung auch bei REMs erfolgen, die normalerweise mit evakuierter Probenkammer betrieben werden. Die leichte Umrüstbarkeit zwischen den beiden Anwendungsfällen stellt einen Vorteil der Erfindung dar.

Weitere Ausführungsformen und Vorteile der Erfindung werden aus den beibefügten Zeichnungen und ihrer Beschreibung ersichtlich. Es zeigen:
- Fig.1: eine schematische Darstellung einer erfindungsgemäßen Anordnung von Druckstufenblenden. Objektivlinse, Elektroden und Detektor für ein Druck-REM,
- Fig.2: einen Ausschnitt aus Fig. 1, in dem die Druckstufenblenden dargestellt sind,
- Fig.3: analog zu Fig. 2 eine schematische Darstellung mit einer schichtweise aufgebauten Druckstufenblende,
- Fig.4: für einen etwas größeren Ausschnitt als in Fig. 2 eine schematische Darstellung einer weiteren Variante eines erfindungsgemäßen Druck-REMs, insbesondere mit einer modifizierten Befestigung der oberen Druckstufenblende,
- Fig.5: eine schematische Darstellung eines etwas größeren Ausschnitts als in Fig. 2 für eine weitere Variante eines erfindungsgemäßen Druck-REMs mit einer schichtweise aufgebauten oberen Druckstufenblende, die zusätzliche Öffnungen für den Durchtritt von Sekundärelektronen aufweist,
- Fig.6: eine schematische Darstellung eines Ausführungsbeispiels mit einer rein magnetischen Objektivlinse,
- Fig.7: eine schematische Darstellung eines weiteren Ausführungsbeispiels mit einer rein magnetischen Objektivlinse,
- Fig.8: eine schematische Darstellung einer Erweiterung des Ausführungsbeispiels aus Fig. 1 mit einem zusätzlichen oberen Detektor, und
- Fig.9: eine Abwandlung des Ausführungsbeispiels aus Fig. 8 mit einer anderen Variante des zusätzlichen oberen Detektors.

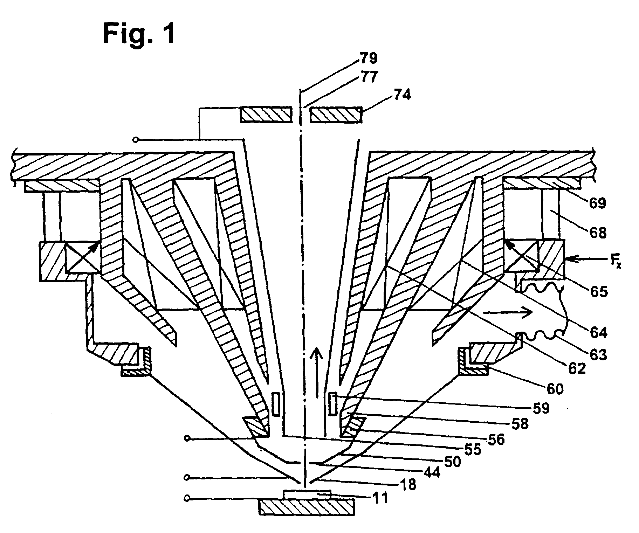

Die Darstellungen in den Figuren beschränken sich auf die zum Verständnis der Erfindung wichtigen Komponenten im Bereich zwischen der Probe und dem Detektor. Die übrigen Teile eines Rasterelektronenmikroskops, zu denen beispielsweise Gehäusewände. Vakuumpumpen, Vakuumleitungen, die Kathode, die Elektroden zur Strahlformung, die Kondensorlinse, die Aperturblende, die Stigmatoren, die Alignment-Spulen und Steuereinrichtungen zählen, sind nicht dargestellt. So zeigt insbesondere Fig. 1 für ein Ausführungsbeispiel eines erfindungsgemäßen Druck-REMs die für das Verständnis der Erfindung wesentlichen Bestandteile.

Der Primärelektronenstrahl gelangt längs der optischen Achse **79** von oben durch die Öffnung **77** des Detektors **74**. Die zum Abrastem der Probe **11** erforderliche Ablenkung des Primärelektronenstrahles wird mit Hilfe der Ablenkspulen **59** erzeugt. Die Fokussierung des Primärelektronenstrahles geschieht mit Hilfe der von den Elektroden **44, 50** und **55** gebildeten elektrostatischen Linse und des von der magnetischen Linse **62** und/oder von der magnetischen Einpollinse **64** erzeugten Magnetfeldes. Einen weiteren Beitrag zur Fokussierung des Primärelektronenstrahles liefert das elektrische Feld zwischen der Elektrode **44** und der Elektrode **18.** Es ist auch möglich, die magnetische Linse **62** mit zur optischen Achse hin geöffnetem Polschuhspalt oder die magnetische Einpollinse **64** wegzulassen.

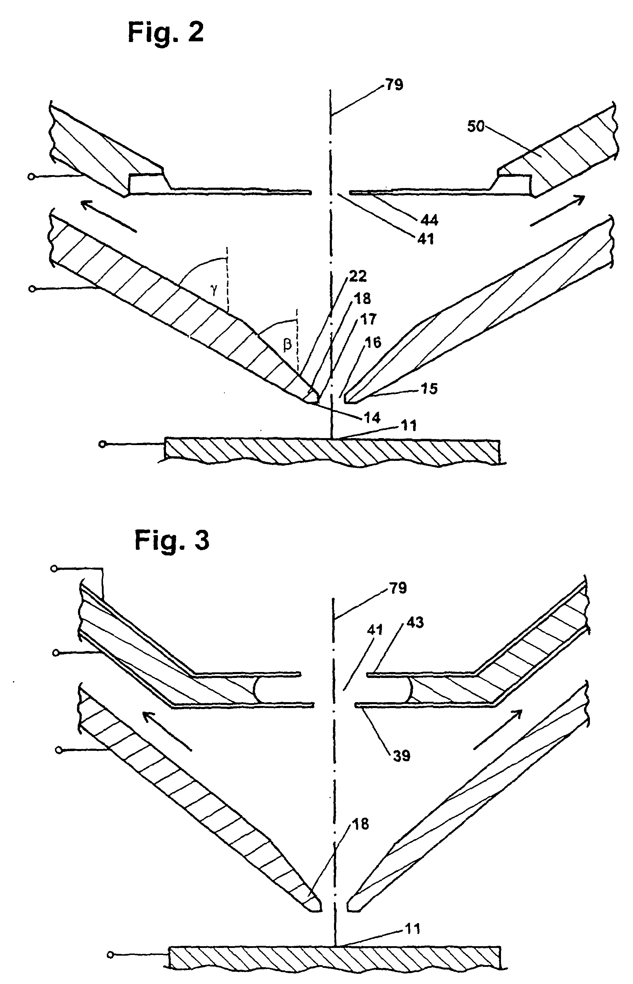

Die Elektrode **55** liegt gegenüber den Elektroden **44** und **50** auf stark positivem Potential. Die Potentialdifferenz beträgt bevorzugt 1 bis 15 kV und kann beispielsweise 7 keV betragen. Die Elektroden **50** und **44** sind über die Isolierung **56** am Polschuh **58** zentriert. Die Elektrode **44** liegt gegenüber der Elektrode **18** auf positivem Potential mit einer bevorzugten Potentialdifferenz von 50 bis 2000 V. Die Elektrode **18,** die über die Isolierung **60** befestigt ist, liegt gegenüber der Probe **11** auf positivem oder auf demselben Potential. Die Größe der angelegten Spannungen wird weiter unten in Zusammenhang mit Fig. 2 besprochen.

Da die beiden Elektroden **18** und **44** eine elektrostatische Linse bilden, ist es für die Auflösung vorteilhaft, daß die kegelstumpfförmige Elektrode **18** während des Betriebes mit großer Genauigkeit in Bezug auf die optische Achse **79** zentriert werden kann. Eine geeignete Möglichkeit hierfür besteht beispielsweise in der Verwendung von Mikrometerschrauben und/oder geregelten Piezostellsystemen, deren Krafteinwirkungen F_{X} und F_{Y} (in x- und y-Richtung) im dargestellten Ausführungsbeispiel die über den Umfang verteilten Rundstäbe **68** elastisch verformen. Die Elektrode **44** muß nicht so genau zentrierbar sein wie die Elektrode **18**, da die Äquipotentialflächen des elektrischen Feldes im Bereich der Öffnung **41** der Elektrode **44** nahezu eben sind.

Die Elektroden **18** und **44** sind gleichzeitig als Druckstufenblenden ausgebildet. Durch die Öffnung der Druckstufenblende **18** strömt Gas aus der Probenkammer nach oben in die Mikroskopsäule, das durch den Wellschlauch **63** und durch die Öffnung der Elektrode **55** abgepumpt wird, wie es die Pfeile andeuten. Die Abdichtung der zentrierbaren Druckstufenblende **18** gegenüber dem äußeren Polschuh erfolgt durch den Simmerring **65.**

Bei der in Fig. 1 dargestellten Ausführung können diejenigen Bauteile (**18, 44, 50, 56, 60,** **63, 65, 68, 69**), die beim Betrieb mit Vakuum in der Probenkammer eine unnötige Begrenzung für das Blickfeld und den Arbeitsabstand darstellen, leicht ausgebaut werden, um das Druck-REM im Vakuumbetrieb ohne sie mit einer anderen Elektrode **50** zu betreiben. Zu diesem Zweck kann das Bauteil **69** von dem darüberliegenden Teil losgeschraubt werden und ist die Isolierung **56** leicht demontierbar am Polschuh **58** befestigt. Weiterhin ist die Druckstufenblende **18** leicht auswechselbar, so daß je nach Anwendungsfall Druckstufenblenden mit unterschiedlich großen Öffnungen verwendet werden können.

Ein vergrößerter Ausschnitt aus Fig. 1 mit den Druckstufenblenden **18** und **44** und der Probe **11** ist in Fig. 2 schematisch dargestellt. Die Elektrode **44** liegt gegenüber der Elektrode **18** auf positivem Potential, dessen Größe so gewählt ist, daß direkt oberhalb und direkt unterhalb der Öffnung **41** etwa dieselbe elektrische Feldstärke herrscht. Hierdurch wird erreicht, daß die Krümmung der Äquipotentialflächen im Bereich der Öffnung **41** möglichst schwach ist. Außerdem ist die obere Druckstufenblende **44** sehr dünn, um eine möglichst geringe Krümmung der Äquipotentialflächen in der Nähe der optischen Achse hervorzurufen. Ihre bevorzugte Dicke in der Nähe der optischen Achse ist kleiner als 300 µm und größer als 0,4µm (z.B. 20 µm). Sie kann entweder aus Metall bestehen (beispielsweise als Dünnschichtblende, die bei Bedarf auch mit dem Primärelektronenstrahl beheizt werden kann) oder kann durch Ätzen insbesondere aus Halbleitermaterial (beispielsweise Silizium) hergestellt werden. Im letztgenannten Fall kann beim Ätzen entweder eine dünne Schicht des Halbleiters stehen gelassen werden oder nur eine Metallschicht übriggelassen werden, die vorher auf den Halbleiter aufgebracht wurde.

Die bevorzugte Größe der Öffnungen **16** und **41** der Druckstufenblenden in Fig. 2 ist abhängig vom gewünschten maximal zulässigen Druck in der Probenkammer, von der gewünschten kleinsten verwendbaren Primärenergie, von der Spannung und dem Abstand zwischen den Elektroden **18** und **44** und von der Güte des Vakuums, das die Kathode (beispielsweise ein Schottky-Emitter) benötigt. Der Durchmesser der Öffnung **16** der Druckstufenblende **18** kann beispielsweise 20 µm bis 500 µm betragen. Bei Verzicht auf die Eignung für niedrige Primärenergien oder bei Beschränkung auf niedrige Drücke in der Probenkammer, kann die Größe der Öffnung **16** aber beispielsweise auch 1000 µm betragen. Der bevorzugte Durchmesser der Öffnung **41** kann beispielsweise 100 µm bis 2000 µm betragen. Er ist vorzugsweise mindestens so groß wie der Durchmesser der Öffnung **16**.

Bei Verwendung von Halbleitermaterial für die Druckstufenblende **18,** kann sie gleichzeitig auch als Halbleiterdetektor für Rückstreuelektronen ausgestaltet werden. Eine Möglichkeit hierfür besteht darin, daß die Unterseite **14** und der untere Bereich der Außenseite **15** der Druckstufenblende n-dotiert und mit einer dünnen Metallschicht bedampft werden, so daß sich ein Schottky-Kontakt ausbildet.

Der Primärelektronenstrahl tritt in Fig. 2 von oben durch die Öffnung 16 in die Probenkammer ein, durchquert das Gas in der Probenkammer und trifft auf die Probe **11**, wo er Sekundärelektronen und Rückstreuelektronen erzeugt. Die Sekundärelektronen haben einen großen Wirkungsquerschnitt für elastische Streuung. Ihre Bewegungsrichtung wird deshalb, ähnlich wie bei einem Diffusionsvorgang, häufig umgelenkt und es besteht die Gefahr, daß sie von der Probe absorbiert werden. Die Sekundärelektronen werden deshalb mit Hilfe eines elektrischen Feldes zur Öffnung **16** gelenkt, das entweder nur aus dem Felddurchgriff durch die Öffnung **16** besteht oder durch das zusätzliche Anlegen einer Spannung zwischen der Probe **11** und der Druckstufenblende **18** erzeugt wird.

In Abhängigkeit vom Gas und Druck in der Probenkammer, Durchmesser der Öffnung **16**, Länge der Bohrungswandung **17,** Kegelöffnungswinkel β und γ der inneren Kegelfläche 22 und Abstand zwischen der Probe **11** und der Druckstufenblende **18** gibt es jeweils eine optimale Spannung zwischen der Probe **11** und der Druckstufenblende **18,** für die die meisten Sekundärelektronen zum Detektor **74** gelangen. Diese Spannung kann zwischen null Volt und einigen hundert Volt liegen. Für kleine Abstände zwischen der Probe **11** und der Druckstufenblende **18** kann der Felddurchgriff durch die Öffnung **16** der Druckstufenblende (in Abhängigkeit von den oben genannten Parametern) ausreichend groß sein, um die Sekundärelektronen zur Öffnung **16** zu lenken. Dann können die Probe **11** und die Druckstufenblende **18** auf demselben Potential liegen.

Das Anlegen einer Spannung zwischen der Probe **11** und der Druckstufenblende **18** hat mehrere Auswirkungen: Es erzeugt ein stärkeres elektrisches Feld und verbessert dadurch den Transport der Sekundärelektronen nach oben zur Druckstufenblende **18.** Gleichzeitig verringert es die Durchwölbung der Äquipotentialflächen nach unten innerhalb und direkt unterhalb der Öffnung **16**, so daß die Sekundärelektronen in diesem Bereich weniger stark zur optischen Achse **79** hin gelenkt werden. Andererseits bewirkt es jedoch zusammen mit der kegelstumpfförmigen Elektrode **18,** daß die Sekundärelektronen weiter unterhalb der Öffnung **16** zur optischen Achse **79** hin gelenkt werden.

Für eine nicht zu große Bohrungslänge der Öffnung **16** und kleine Abstände zwischen der Probe **11** und der Druckstufenblende **18** (je nach Druck in der Probenkammer und Geometrie der Druckstufenblende **18** beispielsweise für Abstände bis zum doppelten Durchmesser der Öffnung **16**) gelangt ein Großteil der Sekundärelektronen auch durch die Öffnung **16,** wenn die Spannung zwischen der Probe **11** und der Druckstufenblende **18** so groß gewählt wird, daß die Feldstärke nahe unterhalb der Öffnung **16** etwa gleich groß ist wie in der Öffnung **16**. Hierdurch nehmen die Verzerrungen am Rand des Gesichtsfeldes ab, so daß das Gesichtsfeld vergrößert werden kann. Dies gilt insbesondere beider Verwendung von Druckstufenblenden **18,** deren innere Kegelfläche **22** einen großen Kegelöffnungswinkel β hat und bei denen die Länge der Bohrungswandung **17** klein ist im Verhältnis zum Durchmesser **16** der Öffnung. Eine andere Möglichkeit zur Vergrößerung des Gesichtsfeides besteht darin, daß die am Rande des Gesichtsfeldes auftretenden Verzerrungen nachträglich mit Hilfe eines Bildverarbeitungsprogrammes korrigiert werden.

Für größere Abstände (beispielsweise 1000 µm) und größere Spannungen (beispielsweise 200 V) zwischen der Probe **11** und der Druckstufenblende **18** erhält man eine Sekundärelektronenkaskade als zusätzliche Vorverstärkung. Bei der Verwendung einer ausreichend großen Druckstufenblendenöffnung **16** (> 200 µm, beispielsweise 250 µm) gelangen genug Sekundärelektronen in die Öffnung **16,** um hiermit auch bei größeren Abständen eine gute Detektionseffizienz zu erhalten.

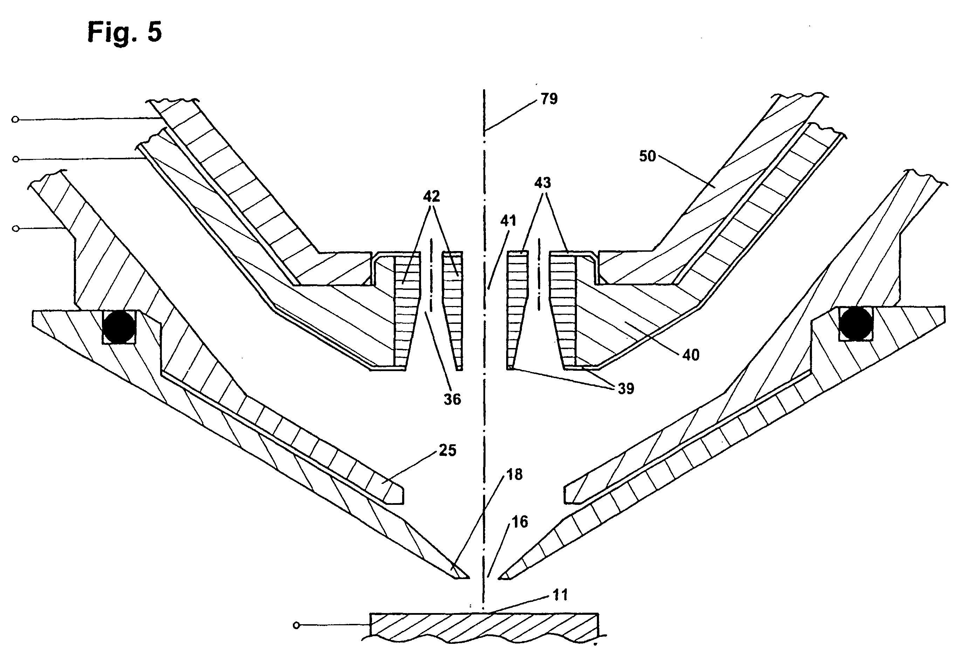

Auch innerhalb der Öffnung **16** der Druckstufenblende ist für den Weitertransport der Sekundärelektronen nach oben das elektrische Feld maßgeblich mitverantwortlich. Der elektrische Feldverlauf ist diesbezüglich um so günstiger, je kleiner die Länge der Bohrung **16** im Vergleich zu ihrem Durchmesser ist. Insofern wird eine Druckstufenblende **18** bevorzugt, wie sie in Fig. 5 dargestellt ist, die gar keine zylindermantelförmige Bohrungswandung **17** hat, sondern statt dessen nur eine scharfe Innenkante als Begrenzung zwischen der Unterseite **14** und der Oberseite **22** der Druckstufenblende aufweist.

Neben den elektrischen Feldern zwischen der Probe **11** und der Druckstufenblende **18** und innerhalb der Öffnung **16** ist auch das Magnetfeld, das durch die in Fig. 1 abgebildete Einpollinse **64** erzeugt wird, sehr hilfreich für den Transport der Sekundärelektronen zur Öffnung **16** und durch die Öffnung **16** hindurch. Durch das Magnetfeld wird die senkrecht zur optischen Achse **79** stehende Bewegungskomponente der Sekundärelektronen mit Hilfe der Lorentzkraft auf eine Kreisbahn umgelenkt. Hierdurch wird erreicht, daß ein von der Probe emittiertes Sekundärelektron auf seinem Weg nach oben seinen Abstand von der optischen Achse **79** zwischen zwei Stößen maximal um seinen doppelten Larmorradius vergrößern kann. Die niederenergetischen Sekundärelektronen, deren Wirkungsquerschnitt für elastische Streuung besonders hoch ist, haben dabei günstigerweise auch einen besonders kleinen Larmorradius. Insbesondere für die Sekundärelektronen mit einer Energie von mehr als 10 eV kommt begünstigend hinzu, daß kleinere Streuwinkel wesentlich wahrscheinlicher sind als große Streuwinkel. Dies führt dazu, daß der Abstand zwischen den Kreismittelpunkten der Bewegung vor dem Stoß und nach dem Stoß wesentlich geringer ist als die Summe der beiden Larmorradien. Da sich die Sekundärelektronen weniger weit von der optischen Achse **79** entfernen können, gelangen bei Verwendung einer Einpollinse mehr Sekundärelektronen durch die Öffnung **16** der Druckstufenblende als ohne Einpollinse.

Für den Transport der Sekundärelektronen durch den Zwischenraum zwischen den Druckstufenblenden **18** und **44** und durch die Öffnung **41** der oberen Druckstufenblende hindurch spielt das Magnetfeld der Einpollinse **64** ebenfalls eine wichtige Rolle, falls es vorhanden ist. Die Druckstufenblenden werden so angeordnet, daß die magnetischen Feldlinien, die durch die Öffnung der unteren Druckstufenblende **18** gehen, auch durch die Öffnung **41** der oberen Druckstufenblende gehen. (Dies ist beispielsweise der Fall, wenn die Öffnung der oberen Druckstufenblende **44** nicht wesentlich kleiner ist als die Öffnung der unteren Druckstufenblende **18** und die obere Druckstufenblende **44** unterhalb des Polschuhs **58** angebracht ist, wie es in den Figuren 1, 6, 7, 8, 9 und 10 dargestellt ist.) Da oberhalb der unteren Druckstufenblende keine starke Streuung mehr stattfindet, wird hierdurch erreicht, daß alle Sekundärelektronen, die durch die untere Druckstufenblende gelangen, auch durch die obere Druckstufenblende gelangen, sofern sie nicht durch die zunehmende magnetische Feldstärke zum Umkehren gezwungen werden. Letzteres trifft nur auf die Sekundärelektronen mit großen Winkeln gegenüber der optischen Achse zu. Durch Anlegen einer zusätzlichen Spannung zwischen den Elektroden **18** und **44** läßt es sich vollständig vermeiden.

Oberhalb der Öffnung **16** der unteren Druckstufenblende **18** in Fig. 2 nimmt der Druck bis zur Öffnung **41** der oberen Druckstufenblende **44** gegenüber dem Druck der Probenkammer um mehrere Zehnerpotenzen ab. Die Druckabnahme ist abhängig von der Größe der Öffnung **16** der unteren Druckstufenblende. Diese Druckabnahme nach oben hin bewirkt eine Zunahme der mittleren freien Weglänge der Sekundärelektronen.

Bei niedrigem Druck (beispielsweise 1 hPa) in der Probenkammer oder kleinem Durchmesser (beispielsweise 200 µm) der unteren Druckstufenblendenöffnung **16** oder wenn die Sekundärelektronen beim Erreichen der Öffnung **16** verhältnismäßig energiereich sind (beispielsweise 20 eV), ist kein zusätzliches elektrisches Feld oberhalb der Druckstufenblende **18** erforderlich, um die Sekundärelektronen durch die obere Druckstufenblendenöffnung **41** zu lenken, wenn das Magnetfeld der Einpollinse **64** vorhanden ist, um die Sekundärelektronen durch die obere Druckstufenblendenöffnung **41** zu lenken.

Falls die Einpollinse **64** nicht vorhanden oder nicht ausreichend stark aktiviert ist, werden die Sekundärelektronen in den Ausführungsbeispielen aus Fig. 2 bis 4 durch das elektrische Feld zwischen den beiden Druckstufenblenden auf die obere Druckstufenblendenöffnung **41** fokussiert, oberhalb der ein gutes Vakuum herrscht, in dem die Sekundärelektronen detektiert werden. Bei diesem Funktionsprinzip ist es erforderlich, daß die Sekundärelektronen keine Stöße mehr ausführen, wenn sie auf die Öffnung **41** der oberen Druckstufenblende fokussiert werden. Dies wird durch die Abnahme des Druckes und die Zunahme der elektrischen Feldstärke oberhalb der Öffnung der unteren Druckstufenblende **18** erreicht. Gleichzeitig mit der Zunahme der mittleren freien Weglänge der Sekundärelektronen nimmt auch die elektrische Feldstärke oberhalb der Öffnung **16** aufgrund der konischen Form der Elektrode **18** nach oben hin stark zu. Beides zusammen führt dazu, daß die Geschwindigkeit, die die Sekundärelektronen zwischen zwei Stößen erreichen, oberhalb der Öffnung **16** stark zunimmt. Da außerdem auch mit zunehmender Geschwindigkeit die mittlere freie Weglänge der Sekundärelektronen zunimmt, werden die Sekundärelektronen oberhalb der Öffnung **16** innerhalb ihrer freien Weglänge so schnell (und nimmt dabei ihre mittlere freie Weglänge so stark zu), daß die Sekundärelektronen keine Stöße mehr ausführen.

Viele Sekundärelektronen haben ihren letzten Stoß also in geringer Entfernung oberhalb der Öffnung **16**. Durch das elektrische Feld zwischen den beiden Elektroden **18** und **44** werden sie anschließend auf die Öffnung **41** der oberen Druckstufenblende fokussiert. Falls die Einpollinse **64** in Betrieb ist, sind beliebige Kegelöffnungswinkel β ≤ 90° möglich. Falls die Einpollinse **64** nicht in Betrieb ist, beträgt der Kegelöffnungswinkel β für die innere Kegelfläche **22** bevorzugt zwischen 20° und 75°.Auch unter der Nebenbedingung, daß die elektrische Feldstärke in der Öffnung **41** und direkt unterhalb der Öffnung **41** gleichgroß sein soll, ist die Fokussierung der Sekundärelektronen auf die Öffnung **41** problemlos möglich. Sogar bei einer vorgegebenen Potentialdifferenz zwischen den Elektroden **44** und **55** und bei vorgegebenen Kegelöffnungswinkein β und γ wird die Fokussierung der Sekundärelektronen auf die Öffnung **41** erreicht, indem die Lage der Elektrode **44** geeignet gewählt wird: Wenn die Elektrode **50** etwas länger ausgeführt wird und dadurch die Elektrode **44** (mit entsprechend kleinerem Außendurchmesser) etwas weiter unten angeordnet ist, erhält man eine geringere elektrische Feldstärke in der Öffnung **41.** Dementsprechend wird auch die Potentialdifferenz zwischen den Elektroden **18** und **44** so stark verringert, daß direkt unterhalb der Öffnung **41** wieder die gleiche Feldstärke herrscht wie in der Öffnung **41**. Hierdurch erhält man eine schwächere Fokussierung der Sekundärelektronen, während gleichzeitig auch noch die Wegstrecke verkürzt wird, auf der die Sekundärelektronen fokussiert werden. (Aufgrund der geringeren Potentialdifferenz zwischen den Elektroden **18** und **50** kann diese Strecke noch weiter verkürzt werden, indem der Abstand zwischen den beiden Elektroden verkleinert wird.)

Es kann also auch ohne das Magnetfeld der Einpollinse **64** durch die Anordnung der Elektrode **44** in geeigneter Höhe immer erreicht werden, daß die Sekundärelektronen durch das elektrische Feld auf die Öffnung **41** fokussiert werden. (Nur für sehr große Kegelöffnungswinkel β ist dies nicht möglich.) Eine weitere Möglichkeit, um die Feldstärke in der Öffnung **41** zu vergrößern und dementsprechend die Fokussierung der Sekundärelektronen zu verstärken, besteht darin, die Elektrode **44** in Fig. 2 mit der ebenen Fläche nach oben in die Öffnung der Elektrode **50** einzubauen.

Falls der Durchmesser der Öffnung **41** so klein gewählt wird, daß sich beim Betrieb ohne ausreichendes Magnetfeld der Einpollinse **64** bei unterschiedlich großem Gasdruck in der Probenkammer die etwas unterschiedliche Fokussierung der Sekundärelektronen bemerkbar macht, besteht eine bevorzugte Ausführungsform darin, daß die Fokussierung der Sekundärelektronen auf die Öffnung **41** eingestellt werden kann. (Es ist dabei keine starke Veränderung der Fokussierung erforderlich.) Die Fokussierung der Sekundärelektronen auf die Öffnung **41** wird beispielsweise erreicht, wenn die Spannung zwischen den Elektroden **18** und **44** und proportional dazu auch die Spannung zwischen den Elektroden **44** und **55** verändert werden kann. Eine andere Möglichkeit besteht darin. daß eine der Druckstufenblenden **18** oder **44** höhenverstellbar (d.h. in ihrer Lage entlang der optischen Achse verstellbar) ist. Eine weitere Möglichkeit zur Veränderung der Fokussierung ergibt sich bei der Verwendung einer nicht als Druckstufenblende wirkenden, zusätzlichen Elektrode mit größerem Öffnungsdurchmesser, die zwischen den Elektroden **18** und **44** angebracht und vorzugsweise über eine Isolierung an einer dieser beiden Elektroden befestigt und zentriert ist. Die Potentiale der Elektrode **18** und der zusätzlichen Elektrode können dann so verändert werden, daß die Äquipotentialflächen in der Öffnung **41** weiterhin eben bleiben, während die Fokussierung der Sekundärelektronen verändert wird. Die hier angesprochene einstellbare oder veränderliche Fokussierung der Elektronen ist insbesondere für große Druckstufenblendenöffnungen **16** wichtig.

Der weitere Weg der Sekundärelektronen oberhalb der Elektrode **44** wird im folgenden anhand von Fig. 1 erläutert. Die Sekundärelektronen werden durch das elektrische Feld zwischen den Elektroden **44** und **55** weiter beschleunigt und fliegen mit hoher kinetischer Energie zum Detektor **74.** Durch die starke Abnahme des Gasdruckes innerhalb und oberhalb der Druckstufenblenden **18** und **44** wird erreicht, daß trotz des erhöhten Druckes in der Probenkammer am Ort des Detektors **74** ein hinreichend gutes Vakuum für den Einsatz von Detektoren mit hoher Nachweisempfindlichkeit vorhanden ist. Als Detektor **74** sind insbesondere Szintillator-Lichtleiter-Kombinationen, Channelplates und Halbleiterdetektoren mit einem Metall-Halbleiter-Übergang oder mit einem p-n-Übergang gut geeignet. Es können auch Szintillator-Photomultiplier-Kombinationen auf der Basis von Plastikszintillatoren, YAG-Szintillatoren, YAP-Szintillatoren und dgl. verwendet werden. Bei Verwendung einer Channelplate ist es empfehlenswert, eine zusätzliche Liner-Elektrode für die Öffnung des Detektors vorzusehen, wie sie in DE 3703029 A1 verwendet wird.

Fig. 3 zeigt für denselben Ausschnitt wie in Fig. 2 eine andere Variante eines erfindungsgemäßen Druck-REMs zur Illustration des oben genannten zweiten Gesichtspunkts. Die obere Druckstufenblende in Fig. 3 ist schichtweise aufgebaut: Ihre Unterseite **39** und Oberseite **43** bestehen aus leitfähigen Materialien, während in ihrem Inneren zumindest eine Schicht aus isolierendem Material besteht. Die Kontaktierung der leitfähigen Schichten **39** und **43** liegt außerhalb des dargestellten Bereiches.

Die Potentiale der Elektroden **18, 39,** und **43** werden so gewählt, daß in den Öffnungen der Elektroden **39** und **43** und im Bereich **41** zwischen den Öffnungen der beiden Elektroden dieselbe elektrische Feldstärke herrscht. Da die bevorzugte Dicke der Elektroden **39** und **43** in der Nähe der optischen Achse **79** sehr klein (≤ 100 µm) ist, sind die Äquipotentialflächen im Bereich der Öffnungen der Elektroden **39** und **43** und im Bereich **41** dazwischen nahezu eben. Der bevorzugte Abstand zwischen den Elektroden **39** und **43** beträgt 10 bis 1000 µm. Eine geeignete Möglichkeit zur Herstellung einer solchen, schichtweise aufgebauten Druckstufenblende mit sehr dünnen Elektroden **39** und **43** besteht beispielsweise darin, daß die Elektroden **39** und **43** Metallbeschichtungen eines Isolators darstellen, zwischen denen der Isolator in einem Bereich um die optische Achse herum weggeätzt wurde. Die Öffnung der Elektrode **39** kann auch gleichgroß oder größer sein als die Öffnung der Elektrode **43** und es können auch mehr als zwei leitfähige Schichten verwendet werden. Weiterhin kann auch die untere Druckstufenblende **18** schichtweise aufgebaut werden. Die leitfähigen Schichten können dabei insbesondere eben, kegelförmig oder kegelstumpfförmig sein. Die Verwendung einer schichtweise aufgebauten unteren Druckstufenblende **18** hat insbesondere als Vorteile, daß der Transport der Sekundärelektronen zum Detektor verbessert wird, daß das Gesichtsfeld vergrößert werden kann und daß der Fehlerkoeffizient der an die Druckstufenblende angrenzenden elektrostatischen Linse verringert werden kann.

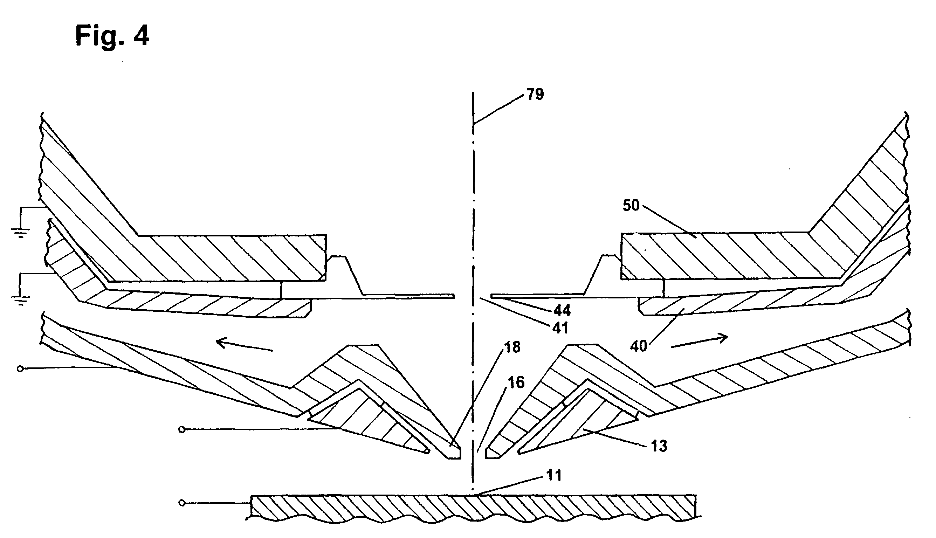

Fig. 4 zeigt für eine andere Variante eines erfindungsgemäßen Druck-REMs einen Ausschnitt mit den Druckstufenblenden. Der Unterschied gegenüber der Variante aus Fig. 2 besteht in der zusätzlichen Halterung **40** für die Druckstufenblende **44** und darin, daß die Elektrode **50** in Fig. 4 ohne die dazwischenliegende Isolierung **56** als direkte Fortsetzung des Polschuhs **58** ausgeführt ist, so daß sie eine besonders gute Zentrierung in Bezug auf die optische Achse aufweist und geerdet ist. Bei dieser Variante ist die Elektrode **50** nicht demontierbar, während die Teile **13, 18, 40, 42** und **44** (und **60, 63, 65, 68** und **69** aus Fig. 1) für den Betrieb des Druck-REMs mit Vakuum in der Probenkammer entfernt werden können. Das nach der Entfernung übrigbleibende REM für den Vakuumbetrieb entspricht, abgesehen von der zusätzlichen Einpollinse, weitgehend den herkömmlichen Bauformen von REMs ,wie sie beispielsweise von den Firmen "ICT" oder "LEO" angeboten werden.

Die als Federelement ausgeführte Halterung **40** hält die Druckstufenblende **44**, die an der Bohrung der Elektrode **50** zentriert ist, in ihrer Lage. Es wäre auch möglich, als Halterung ein Federelement zu verwenden, das sich über eine Isolierung am darunterliegenden Bauteil **18** abstützt. Ferner könnte man die Druckstufenblende **18** auch an der entsprechend umgestalteten Außenkante der Elektrode **50** zentrieren. Es ist auch möglich, die obere Druckstufenblende **44,** ihre Halterung **40** und das zusätzliche Abpumpen durch den Wellschlauch **63** (siehe Fig. 1) wegzulassen. Dies hat den Vorteil eines vereinfachten Aufbaus mit vereinfachter Montierbarkeit, bei dem auch ohne Einpollinse **64** keine Fokussierung der Sekundärelektronen erforderlich ist und kein negativer Einfluß einer oberen Druckstufenblende **44** auf die Fokussierung des Primärelektronenstrahls möglich ist. Es können mit dieser Variante ohne obere Druckstufenblende **44** bei gleichbleibendem Öffnungsdurchmesser der verbleibenden Druckstufenblende **18** jedoch nur wesentlich kleinere Drücke in der Probenkammer verwendet werden. Diese Variante mit nur einer Druckstufenblende unterhalb des Detektors **74** ist deshalb weniger zur Beobachtung feuchter Proben mit großem Gesichtsfeld geeignet, sondern hauptsächlich für Anwendungsfälle, bei denen das Gas in der Probenkammer zur Aufladungsbekämpfung verwendet wird.

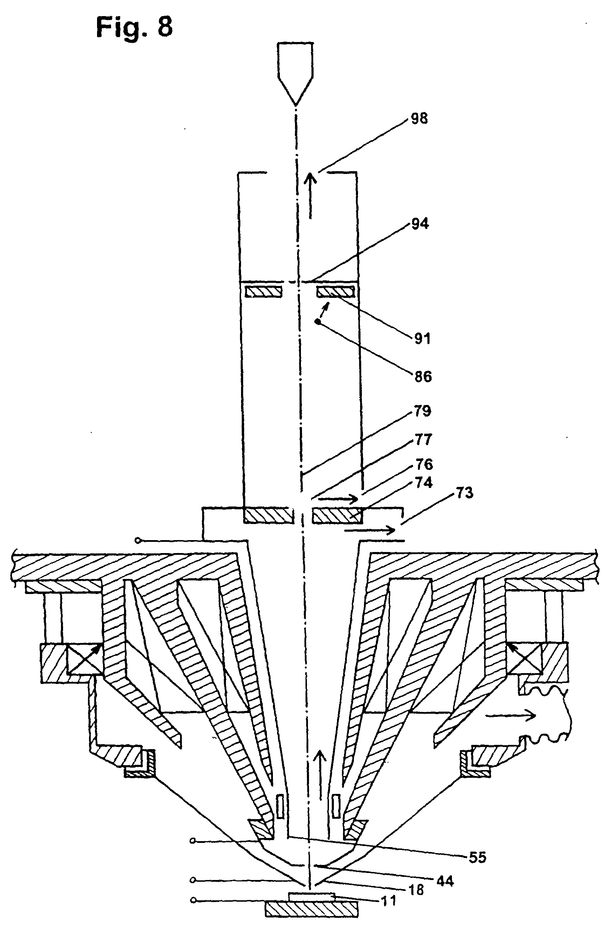

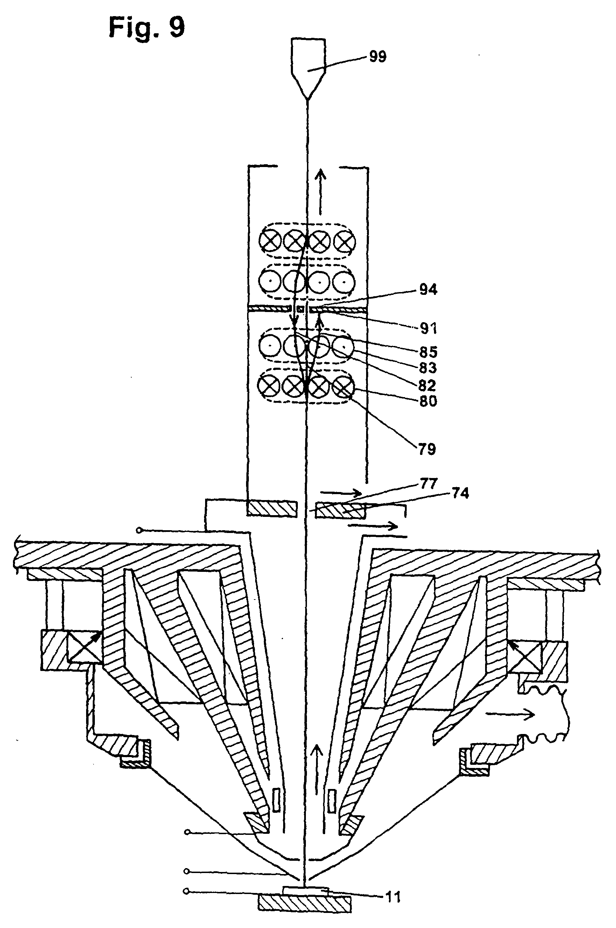

Wenn die Einpollinse **64** nicht in Betrieb ist, wird beim Vakuumbetrieb mit den in Fig. 2 bis Fig. 4 dargestellten Aufbauten nahe oberhalb der Öffnung **16** ein erster Sekundärelektronen-Crossover erhalten, der durch das elektrische Feld zwischen den Elektroden **18** und **44** (bzw. **39**) auf die Öffnung **41** abgebildet wird. Die Fokussierung der Sekundärelektronen auf die Öffnung **41** wird dabei durch das Anlegen einer kleinen Spannung zwischen der Probe **11** und der Elektrode **18** und/oder durch eine der in Zusammenhang mit Fig. 2 beschriebenen Maßnahmen zur Veränderung der Fokussierung der Sekundärelektronen erreicht. Für den Vakuumbetrieb mit den in Fig. 2 bis 4 ausschnittsweise dargestellten Druck-REMs ist die Kombination mit einem zusätzlichen oberen Detektor **91** aus Fig.8 oder Fig.9 vorteilhaft.

Wenn die Einpollinse **64** nicht in Betrieb ist, müssen die Sekundärelektronen in den Ausführungsbeispielen aus Fig. 2 bis 4 auf die Öffnung **41** der oberen Druckstufenblende fokussiert werden. In Fig. 5 ist hingegen ein Ausführungsbeispiel dargestellt, bei dem die Sekundärelektronen auch ohne das Magnetfeld der Einpollinse nicht auf eine bestimmte Stelle fokussiert werden müssen und dementsprechend auch die für die Sekundärelektronen-Fokussierung maßgeblichen Parameter frei gewählt werden können. Ein weiterer Vorteil der in Fig. 5 dargestellten Ausführung besteht darin, daß auch ohne das Magnetfeld der Einpollinse 64 ein sehr großer Anteil der Sekundärelektronen zum Signal des Detektors beiträgt.

Der Weg des Primärelektronenstrahls durch die Öffnungen **41** und **16** zur Probe **11,** die Spannung zwischen der Probe **11** und der Druckstufenblende **18,** der Weg der Sekundärelektronen von der Probe **11** zur Öffnung **16** und durch die Öffnung **16** hindurch, die Größe der Öffnung **16,** die Zunahme der elektrischen Feldstärke oberhalb der Öffnung **16** und die Druckabnahme oberhalb der Öffnung **16** sind dieselben wie in Fig. 2. Statt der dünnwandigen Druckstufenblende **44** in Fig. 2 wird in Fig. 5 jedoch das dickwandige Bauteil **42** verwendet. Seine bevorzugte Dicke (Länge des Durchgangs **41**) beträgt 0,4 mm bis 6 mm. Es ist schichtweise aus isolierenden und leitfähigen Schichten aufgebaut, die senkrecht zur optischen Achse **79** verlaufen und in Fig. 5 durch die horizontale Schraffur des Bauteils **42** angedeutet sind. Die leitfähigen Schichten haben dabei eine bevorzugte Dicke von weniger als 200 µm, während die isolierenden Schichten auch dicker sein können. Das Bauteil **42** ist in die isolierende Halterung **40** eingepaßt, die das Bauteil **42** an der Bohrung der Elektrode **50** zentriert. Die Oberseite des Bauteils **42** ist von der leitfähigen Schicht **43** bedeckt, die eine Elektrode bildet, die auf demselben Potential wie die Elektrode **50** liegt. Die Unterseiten des Bauteils **42** und der Halterung **40** sind von der leitfähigen Schicht **39** bedeckt. Sie bildet eine Elektrode, die gegenüber der Elektrode **43** auf negativem Potential liegt. Das Bauteil **42** hat einen mittleren Durchgang **41** um die optische Achse 79 herum und zusätzlich noch mehrere Durchgänge **36** über den Umfang verteilt.

Die Oberfläche der Durchgänge **36** und **41** ist mit einer schlecht leitfähigen Schicht bedeckt, deren elektrische Parameter beispielsweise denen einer schlecht leitfähigen Schicht entsprechen, wie sie in einem Channeltron oder einer Channelplate verwendet wird. Die schlecht leitfähige Schicht in den Durchgängen **36** und **41** hat einen Gesamtwiderstand, der entlang der optischen Achse gleichmäßig verteilt ist. (Um eine gleichmäßige Verteilung des Widerstandes längs der optischen Achse zu erreichen, kann auch eine zusätzliche schlecht leitfähige Schicht an der Grenzfläche zum Bauteil **40** auf dem Bauteil **42** aufgebracht sein). Dadurch entsteht zwischen den Elektroden **39** und **43**, mit denen die schlecht leitfähige Schicht kontaktiert ist, ein homogenes elektrisches Feld in den Durchgängen **36** und **41**. Der schichtweise Aufbau des Bauteils **42** aus abwechselnd dünnen isolierenden und leitfähigen Schichten ergibt auch bei einer etwas ungleichmäßigen Verteilung der schlecht leitfähigen Schicht im Durchgang **41** ein rotationssymmetrisches elektrisches Feld, so daß eine gute Auflösung erreicht wird.

Die Größe der Spannung zwischen den Elektroden **50** und **55** wurde in Zusammenhang mit Fig. 1 besprochen. Die Spannung zwischen den Elektroden **39** und **43** ist so groß, daß die elektrische Feldstärke innerhalb des Durchgangs **41** gleichgroß ist wie direkt oberhalb des Durchgangs **41**. Die Spannung zwischen den Elektroden **25** und **39** ist so groß, daß die elektrische Feldstärke direkt unterhalb des Durchgangs **41** gleichgroß ist wie innerhalb des Durchgangs **41**. Die Druckstufenblende **18** liegt auf demselben Potential wie die Elektrode **25** und ist leicht demontierbar an der Elektrode **25** befestigt. Eine bevorzugte Ausgestaltung des Aufbaus aus Fig. 5 besteht darin, daß die Druckstufenblende **18** gewechselt werden kann, ohne daß die Probenkammer belüftet wird. Eine entsprechende Vorrichtung zum Auswechseln der Druckstufenblende (nicht dargestellt) kann beispielsweise am Rand des Probentisches angebracht sein.

Die langgestreckten schmalen Durchgänge **36** und **41** stellen einen großen Strömungswiderstand für das Gas dar, das sich unterhalb des Bauteils **42** befindet. Dieser Strömungswiderstand ist um mehr als eine Größenordnung höher als der Strömungswiderstand beim Abpumpen durch die in Fig. 1 dargestellte Elektrode **55.** Der bevorzugte Durchmesser des Durchgangs **41** beträgt 100 bis 2000 µm. Der bevorzugte Durchmesser der Durchgänge **36** ist kleiner als der bevorzugte Durchmesser des Durchgangs **41.** Die Durchgänge **36** können sich, wie in Fig. 5 dargestellt, nach unten hin aufweiten, so daß auf der Unterseite des Bauteils **42** nur schmale Stege zwischen den Durchgängen **36** übrig bleiben. Hierdurch wird der Anteil der Sekundärelektronen, die in die Durchgänge **36** gelangen, vergrößert.

Die Sekundärelektronen gelangen in Fig. 5 (je nach Fokussierung der Sekundärelektronen) in den Durchgang **41** und/oder in die Durchgänge **36**. Wenn ein Sekundärelektron auf die schlecht leitfähige Schicht an der Oberfläche eines Durchgangs trifft, erzeugt es dort mit hoher Wahrscheinlichkeit mindestens ein Sekundärelektron (wie in einem Channeltron oder einer Channelplate) und liefert dadurch einen Beitrag zum Signal des Detektors.

Mit dem in Fig. 5 dargestellten Aufbau ist auch der Betrieb mit Vakuum oder sehr geringem Druck in der Probenkammer möglich. Wenn die untere Druckstufenblende **18** entfernt wird, wird hiermit auch bei großem Abstand (> 5 mm) zwischen der Probe **11** und der Elektrode **25** eine gute Auflösung und eine gute Detektionseffizienz erreicht. Die Spannung zwischen den Elektroden **25** und **39** ist dabei so groß, daß die elektrische Feldstärke direkt unterhalb des Durchgangs **41** gleichgroß ist wie innerhalb des Durchgangs **41**. Ein sehr großes Gesichtsfeld erhält man hiermit bei Verwendung eines Doppelablenkelementes, wenn das Rasterzentrum nahe oberhalb oder in den Durchgang **41** gelegt wird.

Eine besonders vorteilhafte und bevorzugte Ausgestaltung des in Fig. 5 dargestellten Aufbaus besteht darin, daß das Bauteil **42** sehr nahe an der unteren Druckstufenblende **18** angeordnet wird (mit einem bevorzugten Abstand von weniger als 2 mm zur Druckstufenblende **18**). Hierbei wird auf die Durchgänge **36** verzichtet und der Durchgang **41,** das Bauteil **42**. die Isolierung **40** und die leitfähige Schicht **39** verjüngen sich kegelförmig nach unten hin. Für nicht zu kleine Vergröße. rungen (≥ ca. 1000-fach) ergibt diese Variante in Verbindung mit der Einpollinse **64** eine sehr gute Detektionseffizienz. Für kleine Vergrößerungen wird die Einpollinse **64** ausgeschaltet.

Die Ausführungsbeispiele aus Fig. 1, Fig. 3 und Fig. 5 sind mit einer kombinierten elektrostatischen und magnetischen Objektivlinse vorgesehen. Die in Fig. 2 und Fig. 4 dargestellten Ausführungsbeispiele sind sowohl in Verbindung mit einer kombinierten elektrostatischen und magnetischen Objektivlinse, als auch mit einer rein magnetischen Objektivlinse, die ein Magnetfeld zwischen den Druckstufenblenden erzeugt (beispielsweise einer Einpollinse), funktionstüchtig. Im Fall einer rein magnetischen Objektivlinse, kann die Spannung zwischen den Druckstufenblenden **18** und **44** geringer sein als bei einer kombinierten elektrostatischen und magnetischen Objektivlinse oder beide Druckstufenblenden können sogar auf demselben Potential liegen. Durch die geringere elektrische Feldstärke im Bereich der oberen Druckstufenblende **44** entfällt auch die Notwendigkeit einer besonders dünnen Druckstufenblende **44**, sondern es können beispielsweise auch handelsübliche Aperturblende als Druckstufenblende verwendet werden.

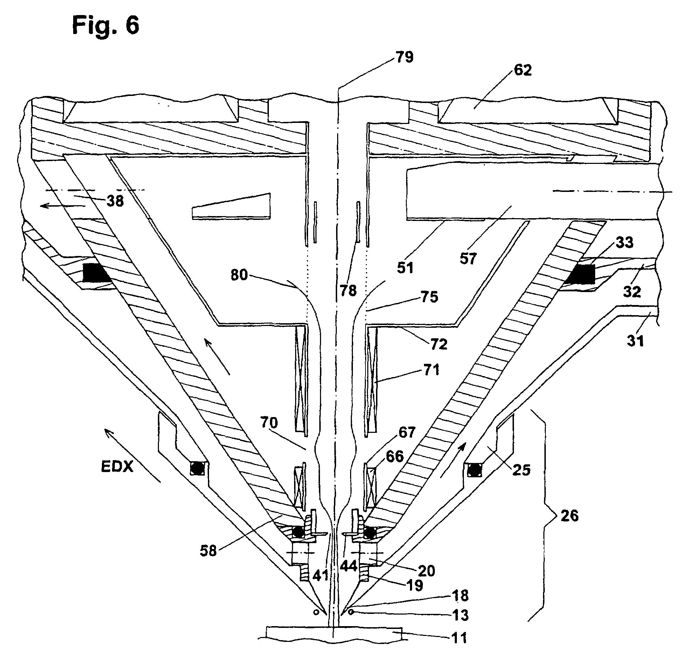

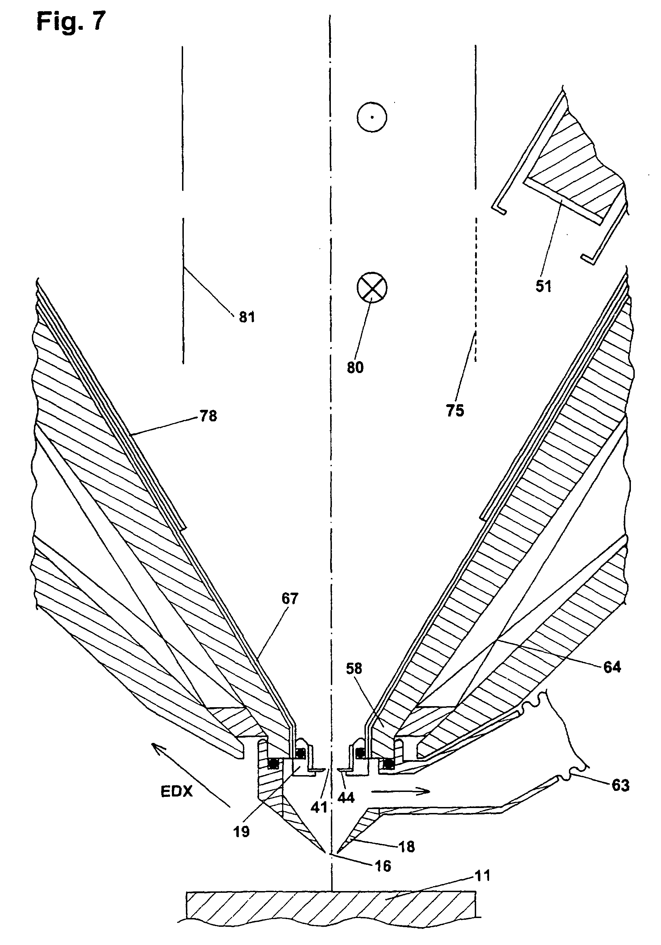

Fig. 6 und Fig. 7 zeigen Ausführungsbeispiele mit rein magnetischer Objektivlinse. In Fig. 6 ist ein Ausschnitt aus einer Objektivlinse zu sehen, wie sie an sich aus EP 0767482 (Fig. 1) bekannt ist. Diese Objektivlinse kann sowohl mit der Linse **62** mit axialem Polschuhspalt, als auch mit der außerhalb des in Fig. 6 dargestellten Bereiches liegenden Einpoilinse betrieben werden, deren innerer Polschuh **58** bis nahe zur Probe reicht. Beim Betrieb mit der Einpollinse findet die Detektion in Fig. 6 in dem Bereich zwischen dem Polschuh **58** und der Linse **62** statt, der gegenüber den Magnetfeldern der beiden Objektivlinsen abgeschirmt ist. Dabei wird das Signal mit Hilfe eines Lichtleiters durch eine Bohrung im Polschuh **58** weitergeleitet, um außerhalb des dargestellten Bereiches von einem Photomultiplier verstärkt zu werden. Wenn die Einpollinse nicht in Betrieb ist, ist mit dem in Fig. 6 dargestellten Aufbau der Betrieb mit Gas in der Probenkammer nur für Arbeitsabstände ab ungefähr einem Millimeter mit einer Kollektorelektrode oder einem Gasszintillationsdetektor möglich. In Fig. 6 findet die Detektion in diesem Fall mit Hilfe der Kollektorelektrode **13** statt und es wird bevorzugt ein Doppelablenkelement verwendet, mit dem um einen Punkt zwischen den beiden Druckstufenblenden gerastert wird.

Die elektrische Feldstärke oberhalb der Druckstufenblende **18** kann bei der Gestaltung gemäß den Figuren 6 und 7 in breiten Bereichen frei gewählt werden. Sie kann wesentlich geringer sein als bei der Gestaltung gemäß den Figuren 2 bis 5 mit kombinierter elektrostatischer und magnetischer Objektivlinse und kann auch ganz verschwinden, wie in Fig. 6, in der die beiden Druckstufenblenden **18** und **44** auf demselben Potential liegen. Dies hat den Vorteil, daß die beiden Druckstufenblenden mit Hilfe des leitfähigen Bauteils **19** in einer sehr einfachen Konstruktion zu einer Baugruppe **26** zusammengefaßt werden können, die (wie in Fig. 5) leicht demontierbar an dem Bauteil **25** befestigt ist.

In Fig. 6 ist oberhalb der unteren Druckstufenblende **18** keine Elektrode vorgesehen, die demgegenüber auf positivem Potential liegt. Eine gegenüber Fig. 6 noch weiter verbesserte Detektionseffizienz erhält man hingegen mit einer Abwandlung des in Fig. 6 dargestellten Ausführungsbeispiels, bei der die obere Druckstufenblende **44** auf positivem Potential gegenüber der unteren Druckstufenblende **18** liegt. Die obere Druckstufenblende kann dann vorteilhaft über den Polschuh 58 oder über die Elektrode 67 kontaktiert werden und das Bauteil **19** hat eine geringere Bauhöhe und einen größeren Außendurchmesser und beinhaltet eine Isolation.

Der Primärelektronenstrahl verläuft in Fig. 6 in Nähe der optischen Achse **79** und wird durch das Magnetfeld der Linse **62** mit axialem Polschuhspalt und/oder durch das Magnetfeld der Einpollinse auf die Probe **11** fokussiert. Der Weg des Primärelektronenstrahls durch die Öffnung der Druckstufenblende **18** zur Probe **11,** die Spannung zwischen der Probe **11** und der Druckstufenblende **18** und die Bewegung der Sekundärelektronen von der Probe **11** zur Öffnung der Druckstufenblende **18** sind in Fig. 6 dieselben wie in Fig. 2 bei Verwendung der Einpollinse **64.** Der Unterschied besteht darin, daß in Fig. 6 kein elektrisches Feld oberhalb der Druckstufenblende **18** und damit auch kein Felddurchgriff nach unten durch die Öffnung der Druckstufenblende **18** vorhanden ist, so daß die Probe **11** und die Druckstufenblende **18** nicht auf demselben Potential liegen dürfen, sondern die Druckstufenblende gegenüber der Probe auf positivem Potential liegen sollte.

Je nach Gasdruck, Öffnungsdurchmesser der Druckstufenblende **18.** Abstand zwischen der Probe und der Druckstufenblende, Probenkippung, Primärenergie und Vergrößerung beträgt die bevorzugte Spannung zwischen der Probe und der Druckstufenblende in Fig. 6 beim Betrieb mit angeregter Einpollinse wenige Volt bis einige hundert Volt. Bei Wasserdampf mit beispielsweise 10 mbar Gasdruck, einer magnetischen Flußdichte von beispielsweise 200 mT am Ort der Probe und beispielsweise 250 µm als Druckstufenblendenöffnungsdurchmesser und als Abstand zwischen der Probe und der Druckstufenblende ist beispielsweise eine Spannung von wenigen Volt ausreichend für den Transport der Sekundärelektronen zur unteren Druckstufenblendenöffnung. Für die oben angesprochene Abwandlung des in Fig. 6 dargestellten Ausführungsbeispiels, bei der die obere Druckstufenblende **44** auf positivem Potential gegenüber der unteren Druckstufenblende **18** liegt, findet auch bei dieser geringen Spannung zwischen der Probe und der Druckstufenblende ein effektiver Weitertransport der Sekundärelektronen oberhalb der unteren Druckstufenblende **18** statt. Für das in Fig. 6 dargestellte Ausführungsbeispiel, ohne elektrisches Feld im Bereich innerhalb und oberhalb der unteren Druckstufenblendenöffnung, haben die dort ankommenden Sekundärelektronen mit einer Energie von wenigen Elektronenvolt jedoch eine nur schwach vorwärts gerichtete Winkelverteilung ihrer Bewegungsrichtung und führen elastische Stöße mit verhältnismäßig großen mittleren Streuwinkeln aus. Eine geringere Streuwahrscheinlichkeit, einen geringeren mittleren Streuwinkel und eine stärker vorwärts gerichtete Winkelverteilung der Bewegungsrichtung erhält man hingegen, wenn man beispielsweise eine Spannung von 20 Volt anlegt. Wesentlich höhere Spannungen bis zu mehreren hundert Volt können je nach Probenkippung und Vergrößerung ebenfalls vorteilhaft sein, weil unter den Bedingungen des obigen Beispiels dann eine schwache Sekundärelektronenkaskade entstehen würde. Der Verstärkungsfaktor wäre im Zusammenhang mit einer Kollektorelektrode oder einem Gasszintillationsdetektor zwar völlig ungenügend, stellt im Zusammenhang mit dem hochempfindlichen Detektor **51** jedoch einen zusätzlichen Gewinn dar, der den durch die breitere Energieverteilung etwas verringerten Anteil der Sekundärelektronen, die den Detektor **51** erreichen, je nach Aufbau des Detektors, durchaus überkompensieren kann.

Das durch die Öffnung **16** aus der Probenkammer einströmende Gas wird durch die seitliche Öffnungen **20** und das Rohr **31** abgepumpt. Wie in Fig. 2 findet auch in Fig. 6 eine starke Druckabnahme oberhalb der Öffnung **16** und eine Zunahme der mittleren freien Weglänge der Sekundärelektronen statt, so daß viele Sekundärelektronen ihren letzten Stoß in geringer Entfernung oberhalb der Öffnung **16** haben. Beim Betrieb mit angeregter Einpollinse werden die Sekundärelektronen auf Spiralbahnen gezwungen, auf denen sie durch die obere Druckstufenblendenöffnung **41** gelangen.

Die bevorzugte Größe der Öffnungen der Druckstufenblenden **18** und **44** ist abhängig vom gewünschten maximal zulässigen Druck in der Probenkammer, von der gewünschten kleinsten verwendbaren Primärenergie und von der Güte des Vakuums, das die Kathode benötigt. Es ist möglich, oberhalb der Druckstufenblende **44** weitere Druckstufenblenden einzufügen und die entstehenden Zwischenräume zu evakuieren. Die bevorzugten Durchmesser der Öffnungen der Druckstufenblenden **18** und **44** sind dieselben wie in Fig. 2, wobei die Öffnung **41** aber auch kleiner sein kann als die Öffnung der unteren Druckstufenblende **18**. Denn die durch die Einpollinse erzeugte magnetische Flußdichte ist in der oberen Druckstufenblendenöffnung **41** wesentlich größer (und der Larmorradius der Sekundärelektronen ist wesentlich kleiner) als in der Öffnung der unteren Druckstufenblende **18.** Deshalb kann auch mit einer kleineren oberen Druckstufenblende erreicht werden, daß alle magnetischen Feldlinien, die durch die Öffnung der unteren Druckstufenblende gehen, auch durch die obere Druckstufenblendenöffnung gehen und dementsprechend auch nahezu alle Sekundärelektronen, deren Geschwindigkeitskomponente in Richtung der optischen Achse groß genug ist, so daß sie nicht durch die zunehmende magnetische Flußdichte zum Umkehren gezwungen werden. Bei der oben angesprochenen Abwandlung von Fig. 6, bei der die obere Druckstufenblende **44** gegenüber der unteren Druckstufenblende **18** auf positivem Potential liegt, gelangen sogar nahezu alle Sekundärelektronen, die durch die untere Drackstufenblende kommen, auch durch die obere Druckstufenblende.

Mit dem dargestellten Aufbau ist bei angeregter Einpollinse nicht nur der Betrieb mit Gas in der Probenkammer, sondern auch der Betrieb mit Vakuum in der Probenkammer möglich, wobei sich die Sekundärelektronen auf Spiralbahnen durch die Druckstufenblenden bewegen.

Um den qualitativen Verlauf der Magnetfelder zu veranschaulichen, sind in Fig. 6 beispielhaft zwei magnetische Feldlinien von der Probe bis zum Innenraum des Detektorgehäuses **72** eingezeichnet. Oberhalb der Druckstufenblendenöffnung **41** nimmt die magnetische Feldstärke stark ab. Das starke Magnetfeld der Einpollinse wird durch das sehr viel schwächere Magnetfeld der Zylinderspulen **66** und **71** abgelöst, das die Sekundärelektronen weiterhin nach oben leitet. Die Symmetrieachse dieser Magnetfelder fällt mit der optischen Achse zusammen. Oberhalb der Zylinderspule **71** befindet sich eine Gegenelektrode **78**, die gegenüber dem Detektorgehäuse **72** auf negatives Potential gelegt werden kann und mit der die Sekundärelektronen, je nach angelegter Spannung zwischen der Probe **11** und der Druckstufenblende **18,** in Richtung der optischen Achse abgebremst und in Richtung zum Drahtnetz **75** gelenkt werden können. Außerdem werden die Sekundärelektronen durch das von der Spule **71** erzeugte Magnetfeld **80** oberhalb der Zylinderspule **71** zum Drahtnetz **75** gelenkt. Die Sekundärelektronen treten durch das Drahtnetz **75** in das Detektorgehäuse **72** ein. Auf der anderen Seite des Drahtnetzes herrscht ein starkes elektrisches Feld, das die Sekundärelektronen zum Detektor **51** beschleunigt, wo sie detektiert werden.

Die bevorzugte Spannung zwischen dem Drahtnetz **75** und dem Detektor **51** beträgt 1 bis 10 kV. Als Detektor **51** kann beispielsweise ein Halbleiterdetektor oder, wie in Fig. 6 dargestellt, ein Szintillator verwendet werden. Die Verwendung eines solchen, hochempfindlichen Sekundärelektronendetektors, dessen Hochspannung beim Gasdruck der Probenkammer unweigerlich zu Überschlägen führen würde, ist der Grund für das wesentlich bessere Signal-zu-Rausch-Verhältnis, das mit dem in Fig. 6 dargestellten Ausführungsbeispiel im Vergleich zu den bisher bekannten Rasterelektronenmikroskopen mit Gas in der Probenkammer erhalten wird.

Der Raum oberhalb der Druckstufenblende **44** wird durch den Zwischenraum zwischen den Zylinderspulen, die auch in mehr als zwei Teile aufgeteilt sein können, und anschließend durch die aus elektronenoptischen Gründen sowieso vorgesehenen zusätzlichen Bohrungen **38** abgepumpt. Das Rohr **32,** durch das dabei abgepumpt wird, mündet in ein Bauteil, das gegenüber dem Polschuh durch die Dichtung **33** abgedichtet ist.

Eine starke konstruktive Vereinfachung in Fig. 6 kann erreicht werden, indem das Bauteil **25**, das Rohr **31,** die untere Druckstufenblende **18** und der dadurch überflüssigwerdende Teil des Bauteils **19** weggelassen werden. Bei gleichem Druck in der Probenkammer ist dann allerdings nur ein Betrieb mit sehr viel kleinerer Druckstufenblendenöffnung **41** möglich.

Zur Durchführung von eriergiedispersiver Röntgenspektroskopie (EDX) mit den Ausführungsbeispielen aus Fig. 6 (oder seiner oben genannten Abwandlung mit einer zusätzlichen Spannung zwischen den beiden Druckstufenblenden) und Fig. 7 ist in der Probenkammer außerhalb des dargestellten Bereiches in Richtung des mit "EDX" beschrifteten Pfeils ein EDX-Detektor angebracht. In Fig. 1 ist dies ebenfalls möglich. In Fig. 6 wird dabei bevorzugt ein Vorsatz **26** ohne Kollektorelektrode **13** verwendet, um die EDX-Detektion bei einem kleinen Abstand zwischen der Druckstufenblende **18** und der Probe **11** zu ermöglichen.

Der Abstand zwischen der Dmckstufenblende **18** und der Probe **11** ist für EDX bevorzugt größer als der Durchmesser der Öffnung der Druckstufenblende **18** und kleiner als 1,5 Millimeter. Zwischen der Druckstufenblende und der Probe liegt eine Spannung von bevorzugt **50** bis mehreren 100 Volt, beispielsweise von 300 Volt an. Der Gasdruck in der Probenkammer wird so hoch gewählt, daß Aufladungen durch die von den beschleunigten Sekundärelektronen erzeugten Gasionen ausgeglichen werden. Die Verwendung eines kleinen Abstandes zwischen der Probe und der Druckstufenblende und eines dementsprechend höheren Gasdruckes hat dabei den Vorteil, daß die Gasionen die Probe wesentlich gezielter dort erreichen, wo die Aufladungen erzeugt werden. Sie vergrößert also die Effizienz der Aufladungsbekämpfung durch die Gasionen, indem ein größerer Prozentsatz der Gasionen die Probe in dem kleinen, betrachteten Bereich erreicht. Dadurch wird es möglich, das Produkt p·d (Druck mal Wegstrecke der Primärelektronen durch das Gas) zu verringern und dementsprechend mit verringerter Primärelektronenstreuung zu arbeiten. Außerdem treffen die gestreuten Primärelektronen mit einem geringeren Abstand von der momentan analysierten Probenstelle auf die Probe. Wenn die Einpollinse in Betrieb ist, können simultan zur Aufnahme von EDX-Spektren auch Sekundärelektronenbilder der Probe mit dem hochempfindlichen Detektor 51 aufgenommen werden. Im Gegensatz zu den heute bekannten Detektoren für erhöhten Druck in der Probenkammer eignet er sich besonders gut für den bei EDX vorteilhaften kurzen Abstand zwischen der Probe und der Druckstufenblende. Durch die verringerte Primärelektronenstreuung und das damit verbundene verringerte Signal von umliegenden Probenstellen wird die Nachweisempfindlichkeit in den EDX-Spektren stark verbessert. Wahlweise kann auch die Primärenergie verringert und dadurch die Ortauflösung für die EDX-Spektren verbessert werden. Damit sind die größten Nachteile heutiger EDX-Spektren mit Gas in der Probenkammer verringert.

Den Vorteil einer geringeren Primärelektronenstreuung aufgrund einer effektiveren Aufladungsbekämpfung bei einem verringerten Abstand zwischen der Probe und der Druckstufenblende, wie er durch die Ausführungsbeispiele in Fig. 1 bis Fig. 9 möglich wird, erhält man nicht nur für EDX, sondern für alle Anwendungsfälle im Zusammenhang mit Aufladungsbekämpfung.

Für den beispielsweise bei Metrologiegeräten in der Halbleiterproduktion auftretenden Anwendungsfall der Aufladungsbekämpfung an einer ebenen Probe, die nicht gekippt werden muß, stellt eine Abwandlung der in Fig. 1 bis Fig. 3 dargestellten Ausführungsbeispiele eine bevorzugte Ausführungsform dar. Bei dieser Abwandlung sind beide Druckstufenblenden **18** und **44** eben und sowohl zwischen den Druckstufenblenden als auch zwischen der unteren Druckstufenblende **18** und der Probe **11** liegt ein homogenes elektrisches Feld an. Außerdem ist bei dieser Ausführungsform, bei der die Linse **62** weggelassen werden kann, der innere Polschuh **58** der Einpollinse **64** weit herunter gezogen, so daß das elektrische Feld zwischen der Elektrode **55** und dem Polschuh **58** die elektrostatische Linse bildet. Der Vorteil dieser Ausführungsform besteht neben der einfachen Herstellbarkeit insbesondere in den vergleichsweise geringen Anforderungen an die Zentrierbarkeit der beiden Druckstafenblenden, so daß auch keine Vorrichtung zum Zentrieren der unteren Druckstufenblende **18** erforderlich ist.

Denselben Vorteil der unproblematischen Zentrierung erhält man auch für eine andere Abwandlung des in Fig. 1 und Fig. 2 dargestellten Ausführungsbeispiels, die nicht nur zur Aufladungsbekämpfung vorgesehen ist und bei der die untere Druckstufenblende **18** die in Fig. 1 und Fig. 2 dargestellte konische Form aufweist, so daß auch Probenkippung möglich ist Bei dieser bevorzugten Ausführungsform wird ebenfalls eine Einpollinse **64** verwendet, deren innerer Polschuh **58** weit herunter gezogen ist, so daß er zusammen mit der Elektrode **55** die elektrostatische Linse bildet. Die ebene obere Druckstufenblende **44** liegt bei dieser Ausführungsform aber auf einem positiven Potential gegenüber dem geerdeten Polschuh **58.** Hierdurch wird eine geringe Feldstärke innerhalb der oberen Druckstufenblendenöffnung **41** erreicht, so daß nur eine geringe Spannung zwischen den beiden Druckstufenblenden **41** und **18** erforderlich ist, um ebene Äquipotentialflächen in der oberen Druckstufenblendenöffnung **41** zu erhalten. Aufgrund der geringen Feldstärke zwischen den beiden Druckstufenblenden ist auch bei dieser Ausführungsform die Zentrierung der unteren Druckstufenblende **18** unproblematisch, so daß keine Vorrichtung hierfür erforderlich ist

Wie in Fig. 6 und Fig. 7 ist auch für diese beiden Ausführungsformen vorgesehen, daß die obere Druckstufenblende **44** nahe unterhalb der Unterkante des Polschuhs **58** angeordnet ist, beispielsweise in der Höhe, in der auf der optischen Achse die maximale magnetische Flußdichte herrscht.

Fig. 7 zeigt ein anderes Ausführungsbeispiel für ein erfindungsgemäßes Druck-REM mit ausschließlich magnetischer Objektivlinse, die in diesem Fall lediglich aus der Einpollinse **64** besteht. Der Weg der Primärelektronen zur Probe, die Fokussierung der Primärelektronenstrahls durch die Einpollinse **64**, die bevorzugte Größe der Öffnungen der Druckstufenblenden **18** und **44**, und die bevorzugte Spannung zwischen der Probe **11** und der unteren Druckstufenblende 18 sind dieselben wie bei Fig. 6. Für die Spannung zwischen der Probe und der unteren Druckstufenblende ist allerdings zu beachten, daß Fig. 7 der Abwandlung von Fig. 6 entspricht, bei der die obere Druckstufenblende **44** auf einem positiven Potential gegenüber der unteren Druckstufenblende **18** liegt. Bei dem in Fig. 7 dargestellten Ausführungsbeispiel hat eine geringe Spannung von wenigen Volt zwischen der Probe und der unteren Druckstufenblende den Vorteil, daß die Sekundärelektronen nur eine geringe Geschwindigkeitskomponente senkrecht zur optischen Achse haben. Dies verbessert die Detektionseffienz bei der späteren Detektion. Außerdem haben die Sekundärelektronen mit einer Energie von nur wenigen Elektronenvolt auch einen sehr geringen Larmorradius, haben jedoch einen größeren mittleren Streuwinkel als bei höherer Energie. Ob der positive oder der negative Effekt überwiegt ist abhängig vom Abstand zwischen der Probe und der Druckstufenblende, vom Gasdruck, von der Primärenergie und vom Durchmesser der Druckstufenblendenöffnung **16**.

Es könnten auch in Fig. 7 beide Druckstufenblenden auf dasselbe Potential gelegt werden. Dies hätte den Vorteil, daß sie besonders einfach als ein gemeinsamer Einsatz ausgeführt werden könnten, hätte jedoch den Nachteil einer verringerten Detektionseffizienz im Vergleich zuin dargestellten Aufbau. Die bevorzugte Potentialdifferenz zwischen den beiden Druckstufenblenden **18** und **44** in Fig. 7 beträgt zwischen 5 V und 500 V. In Abhängigkeit von der Anregung der Einpollinse, dem Verlauf des magnetischen Feldes und der Spannung zwischen der Probe **11** und der unteren Druckstufenblende **18** gibt es für die Spannung zwischen den beiden Druckstufenblenden **18** und **44** einen Spannungsgrenzwert, ab dem keine Sekundärelektronen mehr durch die nach oben hin zunehmende magnetische Flußdichte zum Umkehren gezwungen werden, sondern nahezu alle Sekundärelektronen, die durch die untere Druckstufenblendenöffnung **16** gekommen sind, auch durch die obere Druckstufenblendenöffnung **41** gelangen. Neben diesem Spannungsgrenzwert ist aber auch die den Sekundärelektronen zugeführte Energie ein wichtiger Gesichtspunkt für die Wahl der Spannung zwischen den Druckstufenblenden. Die Spannung zwischen der unteren und der oberen Druckstufenblende wird so groß gewählt, daß die Energie der Sekundärelektronen oberhalb der oberen Druckstufenblende **44** mindestens so groß ist wie die Mindestenergie, die erforderlich ist, um den dort divergierenden magnetischen Feldlinien nicht zu folgen, sondern nach oben in Richtung zum Detektor zu fliegen. Durch die Gegenelektrode **78,** die auf dem mittleren Potential der beiden Elektroden **75** und **81** liegt, können die Sekundärelektronen anschließend wieder abgebremst werden.

Der Detektor **51** mit seinem starken Saugfeld befindet sich hinter der Gitterelektrode **75**. Die Sekundärelektronen werden durch das elektrische Feld zwischen den Elektroden **81** und **75** und durch das Magnetfeld **80** zur Gitterelektrode **75** gelenkt. Für die Primärelektronen mit ihrer entgegengesetzten Flugrichtung, heben sich die Kraftwirkungen durch das Magnetfeld und das elektrische Feld hingegen auf und die beiden Felder bilden einen Wienfilter. Um auch bei einer Primärenergie von weniger als 4 keV bei einer verhältnismäßig starken Anregung dieses Wienfilters - beispielsweise zur Ablenkung von 20-eV-Sekundäzelektronen - keinen chromatischen Fehler zu erzeugen, ist oberhalb des Wienfilters ein zweiter, demgegenüber um 180° gedrehter Wienfilter angeordnet, der die Wirkung des unteren Wienfilters für die Primärelektronen kompensiert. Dieser zusätzliche obere Filter muß nicht unmittelbar oberhalb des unteren Wienfilters angeordnet sein, sondern kann auch weiter oben in der Säule sein. Sein statisches Magnetfeld kann beispielsweise auch durch eine Rasterspule erzeugt werden.

Die im Vergleich zum Vakuumbetrieb stärkere Anregung des Wienfilters, der die Sekundärelektronen zum Detektor lenkt, ist vorteilhaft, wenn eine größere Spannung zwischen der Probe und der unteren Druckstufenblende angelegt wird, weil sie dann die Detektionseffizienz erhöht. Eine solche größere Spannung bis hin zu einer Spannung von mehreren hundert Volt kann je nach Betriebsbedingungen vorteilhaft sein. Insbesondere kann bei großem Abstand zwischen der Probe und der unteren Druckstufenblende durch eine Spannung von beispielsweise 100 V bis 500 V eine Sekundärelektronenkaskade erzeugt werden, die dazu führt, daß auch dann noch eine sehr gute Detektionseffzienz erhalten wird, wenn nur ein kleiner Anteil der Sekundärelektronen durch die untere Druckstufenblendenöffnung **16** hindurch gelangt. Hiermit ist der in Fig. 7 dargestellte Aufbau auch für große Arbeitsabstände geeignet. Entsprechendes gilt auch für das Ausführungsbeispiel aus Fig. 6 und für seine Abwandlung mit einer Spannung zwischen den beiden Druckstufenblenden.

Ein typischer Energiewert für das Maximum der Sekundärelektronen-Energieverteilung bei einer Spannung von 400 V zwischen der Probe und der unteren Druckstufenblende liegt beispielsweise bei 22 eV. Dementsprechend ist es vorteilhaft, wenn der Wienfilter entsprechend stark angeregt werden kann, um auch bei einer vorgeschlagenen Sekundärelektronenkaskade die bestmögliche Detektionseffizienz zu erreichen.

Die Vorverstärkung mit Hilfe einer Sekundärelektronenkaskade, die dadurch erreichte gute Detektionseffizienz bei großem Arbeitsabstand und die Vergrößerung des Gesichtsfelds bei großem Arbeitsabstand sind nicht auf das Ausführungsbeispiel aus Fig. 7 beschränkt, sondern werden beim Betrieb mit einer Einpollinse auch in den anderen Ausführungsbeispielen erreicht.

Aufgrund der hohen Primärenergie erscheint die Feldkrümmung, die durch das Anlegen der Spannung zwischen der unteren Druckstafenblende und der Probe im Bereich der unteren Druckstufenblendenöffnung **16** erzeugt wird, unkritisch für die Auflösung. Wegen der verhältnismäßig hohen Energie der Sekundärelektronen und wegen der starken Anregung der Einpollinse erscheint sie auch für die Detektionseffizienz unkritisch. Falls diese Feldkrümmung innerhalb der unteren Druckstufenblendenöffnung **16** aber doch unterdrückt werden soll, ist dies mit einer Hilfselektrode **13**, wie sie in Fig. 4 und Fig. 6 dargestellt ist, leicht möglich. Indem die Hilfselektrode **13** auf ein positives Potential gegenüber der unteren Druckstufenblende **18** gelegt wird, kann die elektrische Feldstärke innerhalb der unteren Druckstufenblendenöffnung **16** so gering gemacht werden, daß sie nicht mehr stört. Der dabei entstehende Bereich mit niedriger elektrischer Feldstärke vor der Druckstufenblendenöffnung **16** verringert außerdem die mittlere Sekundärelektronenenergie, was positiv für die Detektion ist. Der Verstärkungsfaktor der Sekundärelektronenkaskade wird allerdings etwas abgeschwächt.

Nachdem die Sekundärelektronen in Fig. 7 durch die Gitterelektrode **75** gelenkt wurden, werden sie wie in Fig. 6 vom Saugfeld des Detektors **51** erfaßt, dessen bevorzugte Spannung zwischen 1 und 20 kV liegt.

Es ist von Vorteil, daß die Druckstafenblende **44** in Fig. 6 und Fig. 7 leicht auswechselbar ist, so daß sie leicht ersetzt werden kann. Außerdem ist es vorteilhaft, daß innerhalb der oberen Druckstufenblendenöffnung **41** eine hohe magnetische Flußdichte herrscht und die Öffnung **41** bevorzugt so groß ist, daß nicht nur alle Sekundärelektronen, sondern auch die meisten Rückstreuelektronen, die nicht durch die untere Druckstufenblende **18** abgeschattet werden, durch die Öffnung **41** hindurchgelangen. Eine andere bevorzugte Abwandlung der Ausführungsbeispiele aus Fig. 6 und Fig. 7, die einen besonders großen Durchmesser der unteren Druckstufenblendenöffnung **16** erlaubt, besteht darin, daß die obere Druckstufenblendenöffnung **41** gleichgroß oder kleiner ist als die untere Druckstufenblendenöffnung **16.** Nahe unterhalb der oberen Druckstufenblende **44** ist (mit beispielsweise 100 µm, höchstens aber 1 mm Abstand) eine zusätzliche Blende angebracht, deren Öffnungsdurchmesser größer oder gleichgroß ist wie der Öffnungsdurchmesser der oberen Druckstufenblende **44.** Der Zwischenraum zwischen den beiden Blenden ist mit einer regelbaren Gaszufuhr verbunden, durch die beispielsweise Ozon einströmt. Der Partialdruck des Ozons am Ort der Druckstufenblendenöffnung **41** unterscheidet sich vom dortigen Partialdruck des Wasserdampfes beim Betrieb mit maximal erlaubtem Gasdruck in der Probenkammer um einen Faktor von weniger als 100, bevorzugt um einen Faktor von weniger als 20. Falls es wünschenswert ist, kann die obere Druckstufenblende **44** bei diesem Ausführungsbeispiel gleichzeitig auch als Aperturblende verwendet werden.

Die Halterung **19** der oberen Druckstufenblende ist in Fig. 7 leicht demontierbar an der Elektrode **67** befestigt, über die die Druckstufenblende **44** auch kontaktiert ist. Die untere Druckstufenblende **18** ist leicht demontierbar am Polschuh **58** befestigt. Der Zwischenraum zwischen den beiden Druckstufenblenden wird mit Hilfe eines Wellschlauches **63** evakuiert, der beispielsweise leicht demontierbar in der Probenkammer angeflanscht sein kann. Der Wellschlauch **63** behindert die Probenkippbarkeit nur in eine Richtung, so daß die Probe in alle Richtungen gekippt werden kann, wenn sie vorher entsprechend gedreht wird.

Eine vorteilhafte Abwandlung von Fig. 7 besteht darin, daß unterhalb der Probe eine weitere Einpollinse**64** mit nach oben geöffnetem Polschuhspalt angeordnet ist, wie es aus Rastertransmissionselektronenmikroskopen oder Rasterelektronenmikroskopen mit "In-Lens-Betrieb" bekannt ist. Der Vorteil besteht neben verringerten Fehlerkoeffizienten hauptsächlich in einer vergrößerten magnetischen Flußdichte am Ort der Probe. Hierdurch wird erreicht, daß auch bei gleichem Potential der beiden Druckstufenblenden **18** und **44** nur sehr wenig Sekundärelektronen durch die zunehmende magnetische Flußdichte zum Umkehren gezwungen werden. Eine bevorzugte Ausführungsform in Verbindung hiermit besteht deshalb darin, daß die beiden Druckstufenblenden wie in Fig. 6 Teil eines gemeinsamen Einsatzes **26** sind. Eine andere bevorzugte Abwandlung des in Fig. 7 dargestellten Ausführungsbeispieles besteht darin, daß die Detektion unterhalb der Gegenelektrode **78** durch eine Bohrung im Polschuh **58** hindurch stattfindet, durch die hindurch das Saugfeld des Detektors **51** die Sekundärelektronen anzieht. Hierbei ist kein zusätzliches Magnetfeld **80** erforderlich.

In Fig. 1 werden nur diejenigen Sekundärelektronen detektiert, die beim Erreichen des Detektors **74** einen ausreichend großen Abstand von der optischen Achse **79** haben, um nicht durch die Öffnung **77** des Detektors zu fliegen. Die restlichen Sekundärelektronen fliegen durch die Öffnung **77** des Detektors. Um die Detektionseffizienz des Druck-REMs zu erhöhen, werden in dem Ausführungsbeispiel von Fig. 8 auch diese Sekundärelektronen **86** detektiert. Hierzu wird ein zusätzlicher oberer Detektor **91** verwendet, der nahe unterhalb der Aperturblende **94** angebracht ist. Die Elektrode **55** ist nach oben hin bis über die Aperturblende verlängert, und die Aperturblende **94** und der Detektor **91** liegen auf dem Potential der Elektrode 55. Aufgrund der kleinen Baugröße ist beispielsweise die Verwendung eines Halbleiterdetektors (mit nachgeschaltetem Optokoppler) als oberem Detektor **91** vorteilhaft.

Der untere Detektor **74** und die Aperturblende **94** werden gleichzeitig auch als Druckstufenblenden verwendet. Zwischen den Druckstufenblenden **44**, **74** und **94** und oberhalb der Druckstufenblende **94** wird durch die Öffnungen **73, 76** und **98** abgepumpt, wie es die Pfeile andeuten. Für die Verwendung der Aperturblende **94** als Druckstufenblende ist ein elektromagnetischer Aperturblendenwechsler vorteilhaft, weil die Aperturblende dann nicht beweglich zusein braucht.

Fig. 9 zeigt eine andere Variante eines erfindungsgemäßen Druck-REMs mit zusätzlichem oberen Detektor **91**, der hier als Kombination mit der Aperturblende **94** ausgeführt ist. Eine bevorzugte Ausführungsform besteht in der Verwendung von Halbleitermaterial für das kombinierte Bauteil, wobei das Halbleitermaterial im Bereich um die optische Achse **79** herum bis auf eine geringe Dicke (< 100 µm) weggeätzt sein kann, so daß die Aperturblendenöffnungen nur eine geringe Länge haben. Von oben ist eine Metallbeschichtung aufgebracht, die als Aperturblende **94** wirkt und von unten ist das kombinierte Bauteil als Halbleiterdetektor **91** ausgebildet. Für den mit der Aperturblende **94** kombinierten oberen Detektor **91** bestent eine bevorzugte Ausführungsform darin, daß oberhalb der Aperturblende **94** Ultrahochvakuum herrscht, damit die Aperturblende nicht beheizt zu werden braucht.

In Fig. 9 wird der von der Kathode **99** emittierte Primärelektronenstrahl mit Hilfe eines elektromagnetischen Aperturblendenwechslers durch die gewünschte Öffnung der Aperturblende **94** gefädelt. Unterhalb des Detektors **91** wird der Primärelektronenstrahl **82** durch die Magnetfelder **83** und **80** wieder auf die optische Achse gelenkt. Der anschließende Weg ist für die Primärelektronen und die Sekundärelektronen derselbe wie in Fig. 1. Bei dem in Fig. 9 dargestellten Aufbau werden auch die Sekundärelektronen **85** (und Rückstreuelektronen mit geringen Energieverlusten), die längs der optischen Achse durch die Öffnung **77** des unteren Detektors fliegen, durch die Magnetfelder **80** und **83** von der optischen Achse abgelenkt und zum oberen Detektor **91** geleitet.

Der in Fig. 8 und 9 dargestellte zusätzliche obere Detektor **91** kann mit den Ausführungsbeispielen aus Fig. 2 bis Fig. 5 kombiniert werden, sowie mit jedem Korpuskularstrahlgerät, bei dem der primäre Korpuskularstrahl nahe am Rand des Detektors **74** vorbeifliegt(beispielsweise durch eine Öffnung **77** des Detektors) und bei dem zwischen der Probe **11** und dem Detektor **74** ein elektrisches Feld vorhanden ist, das die Sekundärkorpuskeln in Richtung zum Detektor **74** beschleunigt. Die Detektion der Sekundärelektronen bzw. Sekundärkorpuskeln, die am Rand des unteren Detektors **47** vorbei geflogen sind (beispielsweise durch eine Öffnung **77** des Detektors), bewirkt sowohl beim Betrieb mit Gas in der Probenkammer als auch beim Vakuumbetrieb eine Erhöhung der Detektionseffizienz.

Beim Betrieb mit Vakuum in der Probenkammer ohne die Druckstufenblenden **18** und **44** bewirkt der zusätzliche obere Detektor **91** eine starke Verbesserung der Detektionseffizienz, wenn die Sekundärelektronen unter ungünstigen Betriebsbedingungen auf die Öffnung **77** des unteren Detektors fokussiert werden. Weiterhin macht sich die Verbesserung der Detektionseffizienz für die Bildmitte von Bildern mit niedriger Vergrößerung positiv bemerkbar. Bei der Aufnahme von Bildern mit dem unteren Detektor **74** fällt bei niedriger Vergrößerung nämlich ein dunkler Bereich in der Mitte des Bildes auf, der dadurch zustande kommt, daß bei den achsnahen Probenstellen mehr Sekundärelektronen durch die Öffnung **77** des unteren Detektors fliegen als bei den achsfernen Probenstellen. Dieser nachteilige Effekt entfällt, wenn man zum Signal des unteren Detektors **74** das Signal des oberen Detektors **91** hinzuaddiert, das von den Sekundärelektronen stammt, die durch die Öffnung **77** des unteren Detektors geflogen sind. Außerdem bringt der zusätzliche obere Detektor **91** im Vakuumbetrieb ein sehr wertvolles zusätzliches Signal. Es wird insbesondere durch diejenigen Sekundärelektronen erzeugt, die von der Probe unter kleinen Winkeln zur optischen Achse emittiert werden und deshalb vom unteren Detektor **74** nicht detektiert werden können, sondern durch seine Öffnung **77** fliegen. Sie sind für die Untersuchung tiefer Löcher und stark zerklüfteter Strukturen erforderlich, für die der zusätzliche obere Detektor in idealer Weise geeignet ist. Da er von allen Probenstellen nur die Sekundärelektronen erfaßt, die unter kleinen Winkeln zur optischen Achse emittiert werden, erscheint der Boden eines tiefen Loches ähnlich hell wie erhabene Probenstellen. Um im Vakuumbetrieb Sekundärelektronen mit unterschiedlich großen Startwinkeln getrennt nachzuweisen, kann der Detektor **91** in mehrere teilchensensitive Bereiche aufgeteilt sein, die beispielsweise konzentrisch zur optischen Achse angeordnet sein können. Dieselben Vorteile erhält man auch bei der Verwendung des zusätzlichen oberen Detektors in einem Korpuskularstrahlgerät.

Für die Ausführungsbeispiele mit kombinierter elektrostatischer und magnetischer Obj ektivlinse, bei denen das Magnetfeld der Einpollinse **64** nicht in Betrieb ist und die Sekundärelektronen deshalb elektrostatisch auf die obere Druckstufenblendenöffnung **41** fokussiert werden müssen, findet für große Abstände zwischen der Probe **11** und der Druckstufenblende **18** eine Verschlechterung der Auflösung und der Detektionseffizienz statt. Dieser Betriebszustand kann aber durch die Kombination mit anderen Detektoren, die für große Arbeitsabstände gut geeignet sind, weitgehend vermieden werden: Das elektrische Feld zwischen den Elektroden **18** und **44** (bzw. **18** und **39** in Fig. 3 und 5) bildet für erfindungsgemäße Druck-REMs ohne magnetische Einpollinse eine elektrostatische Linse, die bei großem Abstand zur Probe **11** eine Auflösungsverschlechterung bewirkt. Dies kann vermieden werden, indem die elektrostatische Linse beim Betrieb mit großem Arbeitsabstand ausgeschaltet und rein magnetisch fokussiert wird. Hierzu werden die Elektroden **18, 25, 44** (bzw. **39** und **43** in Fig. 3 und 5), **50** und **55** alle auf dasselbe Potential gelegt Für den Betrieb mit Gas in der Probenkammer wird dann ein Kollektorelektroden-Detektor (WO 88/09564 A1, WO 90/04261 A1) oder ein Gasszintillationsdetektor und für den Betrieb mit Vakuum in der Probenkammer ein seitlich angeordneter Everhardt-Thornley-Detektor verwendet. Als Kollektorelektrode wird die Druckstufenblende **18** und/oder eine demgegenüber isolierte Kollektorelektrode **13,** wie sie beispielsweise in Fig. 4 dargestellt ist, verwendet. Mit dem Kollektorelektroden-Detektor, für den bei dem großen Abstand zwischen der Probe **11** und der Druckstufenblende **18** günstige Betriebsbedingungen herrschen, wird dann immerhin dasselbe Signal-zu-Rausch-Verhältnis erreicht wie bei den heute bekannten Druck-REMs.

Das rein magnetische Fokussieren, bei dem die Elektrode **55** auf ein erdnahes Potential (< 1000 V) gelegt wird, ist für Primärenergien ≥ ca. 5 keV auch bei Verwendung einer Feldemissionskathode oder eines Schottky-Emitters ohne wesentliche Auflösungseinbußen möglich(weil die Extraktionselektrode nur bei Primärenergien < ca. 5 keV auf einem stark positivem Potential liegt). Beim Betrieb mit Gas in der Probenkammer macht sich diese Beschränkung auf hohe Primärenergien gar nicht bemerkbar, weil bei einem typischen Gasdruck von beispielsweise 10 hPa für größere Abstände zwischen der Probe **11** und der Druckstufenblende **18** sowieso nur Primärenergien > 5 keV in Frage kommen.

Eine vorteilhafte Ausgestaltung der erfindungsgemäßen Druck-REMs, die bei großem Abstand zwischen der Probe **11** und der Druckstufenblende **18** eine starke Vergrößerung des Gesichtsfeldes bewirkt, besteht darin, daß statt der Ablenkspulen **59** ein Doppelablenkelement verwendet wird. Hiermit kann die Lage des Rasterzentrums auf der optischen Achse frei gewählt werden. Das größtmögliche Gesichtsfeld wird dabei erreicht, wenn um einen Punkt zwischen den beiden Druckstufenblenden **18** und **44** gerastert wird, dessen Lage auf der optischen Achse **79** so gewählt ist, daß das Gesichtsfeld sowohl von der unteren Druckstufenblende **18** als auch von der darüberliegenden Druckstufenblende **44** begrenzt wird.

Für Ausführungsformen der erfindungsgemäßen Druck-REMs, die bei hohem Druck in der Probenkammer (≥ 100 hPa) oder bei sehr geringen Primärenergien (< 1 keV bei beispielsweise 10 hPa Wasserdampf) arbeiten, entstehen Einschränkungen für den Arbeitsabstand und das Gesichtsfeld dadurch, daß hierfür kleine Abstände (< 300 µm) zwischen der Probe **11** und der Druckstufenblende **18** und ein kleiner Durchmesser (< 300 µm) der Öffnung **16** zwingend notwendig sind. Berührungen zwischen der Probe **11** und der Druckstufenblende **18** beim Bewegen des Probentisches können beim Betrieb mit Gas in der Probenkammer nach Vermessung der Probentopographie sicher vermieden werden.

Die Einschränkung des Gesichtsfeldes durch die Druckstufenblendenöffnung **16** kann durch die nachfolgend beschriebenen Ausgestaltungen der erfindungsgemäßen Druck-REMs kompensiert werden. Eine bevorzugte Ausgestaltung besteht in der Kombination mit einem computergesteuerten Probentisch und einer Bildverarbeitung, die es ermöglicht, mehrere elektronenmikroskopische Einzelbilder zu einem größeren Gesamtbild zusammenzusetzen. Eine weitere bevorzugte Ausgestaltung besteht in der Integration eines Auflichtmikroskopes oder eines konfokalen Lasermikroskopes in die Probenkammer. Hiermit wird vor der Untersuchung mit dem Elektronenstrahl von der bereits auf dem Probentisch montierten Probe ein Übersichtsbild aufgenommen und vom Computer gespeichert. In diesem Bild können mit Hilfe des Computers Stellen markiert werden, die dann von dem computergesteuerten Probentisch für die rasterelektronenmikroskopische Untersuchung angefahren werden. Solche lichtmikroskopischen Übersichtsbilder machen rasterelektronenmikroskopische Übersichtsbilder im Druck-REM für die meisten Anwendungen überflüssig.

Wenn mit dem Auflichtmikroskop oder dem konfokalen Lasermikroskop gleichzeitig auch noch die Probentopographie vermessen und vom Computer gespeichert wird, dann kann bei der nachfolgenden Untersuchung mit dem Elektronenstrahl auch der Arbeitsabstand vom Computer ohne zusätzliche Abstandskontrolle eingestellt werden und können beim Bewegen des Probentisches Berührungen zwischen der Probe **11** und der Druckstufenblende **18** sicher vermieden werden.

## Patentansprüche

1. Rasterelektronenmikroskop mit einem Strahlerzeuger und einer Probenkammer, zwischen denen eine oder mehrere Druckstufenblenden angeordnet sind, durch deren Öffnungen ein Primärelektronenstrahl auf eine Probe in der Probenkammer lenkbar ist, und mit einer magnetischen Linse, mit der der Primärelektronenstrahl auf die Probe fokussierbar ist, wobei die der Probe nächste, unterste Druckstufenblende (18), durch die der Primärelektronenstrahl auf die Probe trifft, dazu eingerichtet ist, einen erhöhten Druck in der Probenkammer gegenüber der übrigen Mikroskopsäule des Rasterelektronenmikroskops abzuschirmen und durch ihre Öffnung (16) Sekundärelektronen von der Probe zu mindestens einem Detektor durchzulassen,
**dadurch gekennzeichnet, dass**
der Detektor strahlerzeugerseitig von dem fokussierenden Magnetfeld der magnetischen Linse angeordnet ist und ein gegenüber der Probe positiv vorgespannter Detektor ist und eine Signalvervielfachung derart aufweist, dass von jedem Sekundärelektron im Detektor eine Vielzahl von Photonen, Elektronen oder Elektron-Loch-Paaren erzeugt werden, wobei der Detektor eine Szintillator-Photomultiplier-Kombination, einen Halbleiterdetektor, einen Channelplate-Detektor oder einen Channeltron-Detektor umfasst.

2. Rasterelektronenmikroskop gemäß Anspruch 1, bei dem oberhalb der untersten Druckstufenblende (18) mindestens eine Elektrode (39, 43, 44, 55) angeordnet ist, die gegenüber der Druckstufenblende (18) auf positivem Potential liegt und dazu eingerichtet ist, die Sekundärelektronen von der Probe hin zum Detektor (51, 74, 91) zu lenken.

3. Rasterelektronenmikroskop gemäß Anspruch 1, das zur Detektion der Sekundärelektronen durch die Öffnung mindestens einer Druckstufenblende eingerichtet ist, die schichtweise aus mindestens zwei leitfähigen, voneinander elektrisch isolierten Schichten (39, 43) aufgebaut ist, wobei die leitfähigen Schichten derart mit Potentialen beaufschlagbar sind, dass die Unter- oder Oberseite der jeweiligen Druckstufenblende eine Potentialdifferenz besitzen.

4. Rasterelektronenmikroskop gemäß Anspruch 2 oder 3, bei dem die Druckstufenblende (18) und/oder die darüberliegenden Elektroden (**39, 43, 44, 50, 55**) eine oder mehrere elektrostatische Linsen bilden, die zur Fokussierung des Primärelektronenstrahls im elektrischen Feld zwischen der Druckstufenblende (**18**) und der darüberliegenden Elektrode (**44** bzw. **39**) bzw. zwischen den darüberliegenden Elektroden (**43, 44, 50, 55**) eingerichtet sind.

5. Rasterelektronenmikroskop gemäß Anspruch 2 oder 3, bei dem die Elektroden (**39, 43, 44, 50, 55**) konzentrisch zur optischen Achse des Rasterelektronenmikroskops angeordnet sind.

6. Rasterelektronenmikroskop gemäß einem der Ansprüche 2 bis 5, bei dem die Oberfläche des Detektors (**51, 75, 91**) zumindest in Teilbereichen auf einem Potential liegt, das gegenüber dem Potential der Probe um mehr als 500 V positiv ist.

7. Rasterelektronenmikroskop gemäß einem der Ansprüche 2 bis 5, bei dem die Oberfläche des Detektors (**51, 75, 91**) zumindest in Teilbereichen auf einem Potential liegt, das gegenüber dem Potential der Probe um mehr als 1000 V positiv ist

8. Rasterelektronenmikroskop gemäß einem der Ansprüche 2 bis 7, bei dem eine kombinierte elektrostatische und magnetische Objektivlinse vorgesehen ist.

9. Rasterelektronenmikroskop gemäß einem der Ansprüche 2 bis 8, bei dem eine oder mehrere Elektroden (**39, 44**) oberhalb der Druckstufenblende (**18**) weitere Druekstufenblenden bilden, wobei Pumpeinrichtungen zur Erzeugung von Unterdrücken in den Zwischemäumen zwischen den Druckstufenblenden vorgesehen sind.

10. Rasterelektronenmikroskop gemäß Anspruch 9, bei dem die als Drockstcienblendea gestalteten Elektroden Öffnungen besitzen, die eine charakteristische Dimension von weniger als 1500 µm besitzen.

11. Rasterelektronenmikroskop gemäß einem der Ansprüche 2 bis 10, bei dem ein Komponentenaufbau vorgesehen ist, wobei die zum Mikroskopbetrieb bei erhöhtem Druck in der Probenkammer erforderlichen Bauteile (**13, 18, 19, 31, 32, 39, 40, 42-44, 60, 63, 65, 68, 69**) eine oder mehrere leicht demontierbare Baugruppen in der Probenkammer bilden.

12. Rasterelektronenmikroskop gemäß Anspruch 2, bei dem ein erster Detektor (**74**) mit seinem äußeren Rand oder einer inneren Öffnung (**77**) an den Primärelektronenstrahl angrenzend angeordnet und ein zweiter Detektor (**91**) vorgesehen ist, der in Bezug anf die Bewegungsrichtung der Sekuridärelektronen hinter dem Rand bzw. der Öffnung des ersten Detektors (**74**) positioniert und zur Detektion von Sekundärelektronen (**85, 86**) eingerichtet ist, die sich am Rand vorbei- oder durch eine Öffnung (**77**) hindurchbewegen.

13. Rasterelektronenmikroskop gemäß einem der Ansprüche 2 bis 12, bei dem die Sekundärelektronen mit Hilfe eines Magnetfeldes (**80**) von der optischen Achse abgelenkt werden.

14. Rasterelektronenmikroskop gemäß Anspruch 1, bei dem die Oberfläche des Detektors (**51, 75, 91**) zumindest in Teilbereichen auf einem Potential liegt, das gegenüber dem Potential der Probe um mehr als 500 V positiv ist.

15. Rasterelektronenmikroskop gemäß Anspruch 1, bei dem die Oberfläche des Detektors (**51, 75, 91**) zumindest in Teilbereichen auf einem Potential liegt, das gegenüber dem Potential der Probe um mehr als 1000 V positiv ist.

16. Rasterelektronenmikroskop gemäß Anspruch 1 oder 15, bei dem ein Komponentenaufbau vorgesehen ist, wobei nur zum Mikroskopbetrieb bei erhöhtem Druck in der Probenkammer erforderliche Bauteile (**13, 18, 19, 26, 31, 32, 39, 40, 42-44, 60, 63, 65, 68, 69**) eine oder mehrere leicht demontierbare Baugruppen in der Probenkammer bilden.

17. Rasterelektronenmikroskop gemäß einem der vorhergehenden Ansprüche, bei dem ein Magnetfeld zwischen der Probe (**11**) und der untersten Druckstufenblende (**18**) vorhanden ist, das bezüglich der optischen Achse rotationssymmetrisch ist und das den Transport der Sekundärelektronen von der Probe zur Druckstufenblendenöffnung (**16**) verbessert

18. Rasterelektronenmikroskop gemäß einem der vorhergehenden Ansprüche, bei dem die Sekundämlektronen auf ihrem Weg zum Detektor (**51, 74, 91**) durch nundestens zwei Druckstufenblendenöffnungen (**16, 41**) gehen, in denen ein Magnetfeld derart vorhanden ist, daß sämtliche Magnetfeldlinien, die durch die untere Druckstufenblendenöffnung (**18**) verlaufen, auch durch die obere Druckstuienblendenofmung (**44**) verlaufen.

19. Rasterelektronenmikroskop gemäß einem der vorhergehenden Ansprüche, bei dem neben dem Magnetfeld der Objeidivlinse (**62, 64**) ein zusätzliches Magnetfeld (**80**) eingerichtet ist, das die Sekundärelektronen in Richtung zum Detektor (**51**) lenkt.

20. Rasterelektronenmikroskop gemäß einem der vorhergehenden Ansprüche, bei dem eine Gegenelektrode (**78**) dazu eingerichtet ist, die Sekundärelektronen abzubremsen und **dadurch** den Transport der Sekundärelektronen zum Detektor (**51**) zu unterstützen.

21. Rasterelektronenmikroskop gemäß einem der vorhergehenden Ansprüche, bei dem ein Detektor für energiedispersive Röntgenspektroskopie (EDX) zum Betrieb bei Abständen von weniger als 1,5 mm zwischen der Probe (**11**) und der untersten Dmckstuienblende (**18**) vorgesehen ist.

22. Verfahren zur Aufnahme rasterelektronenmikroskopischer Abbildungen einer Probe, mit den Schritten:
- Anordnung der Probe in einer Probenkammer unter erhöhtem Druck,
- Bestrahlung der Probe mit einem Primärelektronenstrahl, der mit einem Strahlerzeuger erzeugt wird, wobei zwischen dem Strahlerzeuger und der Probe eine oder mehrere Druckstufenblenden und eine magnetische Linse zur Fokussierung des Primärelektonenstrahls auf die Probe angeordnet sind,
- Transport von Sekundärelektronen durch die mindestens eine Druckstufenblende zu einem positiv vorgespannten Detektor (51, 74, 91), der strahlerzeugerseitig von dem fokussierenden Magnetfeld der magnetischen Linse angeordnet ist, wobei der Detektor eine Szintillator-Photomultiplier-Kombination, einen Halbleiter detektor, einen Channelplate-Detektor oder einen Channeltron-Detektor umfaßt,
- Signalvervielfachung im Detektor oder entlang der Detektoroberfläche, wobei von jedem Sekundärelektron eine Vielzahl von Photonen, Elektronen oder Elektronen-Lochpaaren erzeugt werden, und
- Ermittlung der rasterelektronenmikroskopischen Abbildung aus dem Detektorsignal.

## Claims

1. Scanning electron microscope with a beam generator and a sample chamber, between which one or more pressure stage apertures are disposed, through the openings of which a primary electron beam can be directed onto a sample in the sample chamber, and having a magnetic lens, with which the primary electron beam can be focused onto the sample, the lowest pressure stage aperture (18) next to the sample, through which aperture the primary electron beam impinges on the sample, being arranged in order to protect an increased pressure in the sample chamber relative to the remaining microscope column of the scanning electron microscope and to allow through its opening (16) secondary electrons from the sample to at least one detector,
**characterised in that**
the detector is disposed on the beam generator side of the focusing magnetic field of the magnetic lens and, relative to the sample, is a positively pre-biased detector and has a signal multiplication such that, from each secondary electron in the detector, a multiplicity of photons, electrons or electron hole pairs are generated, the detector comprising a scintillator-photomultiplier combination, a semiconductor detector, a channel plate detector or a channeltron detector.

2. Scanning electron microscope according to claim 1, in which at least one electrode (39, 43, 44, 55) is disposed above the lowest pressure stage aperture (18), which electrode is at a positive potential relative to the pressure stage aperture (18) and is arranged in order to direct the secondary electrons from the sample towards the detector (51, 74, 91).

3. Scanning electron microscope according to claim 1, which is arranged for detection of the secondary electrons through the opening of at least one pressure stage aperture which, layerwise, is constructed from at least two conductive layers (39, 43) which are electrically insulated from each other, the conductive layers being able to be supplied with potentials such that the lower or upper side of the respective pressure stage aperture have a potential difference.

4. Scanning electron microscope according to claim 2 or 3, in which the pressure stage aperture (18) and/or the electrodes (39, 43, 44, 50, 55) situated above form one or more electrostatic lenses, which are arranged for focusing the primary electron beam in the electrical field between the pressure stage aperture (18) and the electrode (44 or 39) situated above or between the electrodes (43, 44, 50, 55) situated above.

5. Scanning electron microscope according to claim 2 or 3, in which the electrodes (39, 43, 44, 50, 55) are disposed concentrically relative to the optical axis of the scanning electron microscope.

6. Scanning electron microscope according to one of the claims 2 to 5, in which the surface of the detector (51, 75, 91) is, at least in partial regions, at a potential which is positive relative to the potential of the sample by more than 500 V.

7. Scanning electron microscope according to one of the claims 2 to 5, in which the surface of the detector (51, 75, 91) is, at least in partial regions, at a potential which is positive relative to the potential of the sample by more than 1000 V.

8. Scanning electron microscope according to one of the claims 2 to 7, in which a combined electrostatic and magnetic objective lens is provided.

9. Scanning electron microscope according to one of the claims 2 to 8, in which one or more electrodes (39, 44) form further pressure stage apertures above the pressure stage aperture (18), pump mechanisms being provided for producing low pressures in the intermediate spaces between the pressure stage apertures.

10. Scanning electron microscope according to claim 9, in which the electrodes, which are configured as pressure stage apertures, have openings which have a characteristic dimension of less than 1500 µm.

11. Scanning electron microscope according to one of the claims 2 to 10, in which a component construction is provided, the components (13, 18, 19, 31, 32, 39, 40, 42 - 44, 60, 63, 65, 68, 69) necessary for the microscope operation at increased pressure in the sample chamber forming one or more readily dismountable sub-assemblies in the sample chamber.

12. Scanning electron microscope according to claim 2, in which a first detector (74) is disposed with its outer edge or an inner opening (77) adjacent to the primary electron beam, and a second detector (91) is provided which, with respect to the direction of movement of the secondary electrons is positioned behind the edge or the opening of the first detector (74) and is arranged for the detection of secondary electrons (85, 86) which move past the edge or move through an opening (77).

13. Scanning electron microscope according to one of the claims 2 to 12, in which the secondary electrons are deflected from the optical axis by means of a magnetic field (80).

14. Scanning electron microscope according to claim 1, in which the surface of the detector (51, 75, 91) is, at least in partial regions, at a potential which is positive relative to the potential of the sample by more than 500 V.

15. Scanning electron microscope according to claim 1, in which the surface of the detector (51, 75, 91) is, at least in partial regions, at a potential which is positive relative to the potential of the sample by more than 1000 V.

16. Scanning electron microscope according to claim 1 or 15, in which a component construction is provided, only components (13, 18, 19, 26, 31, 32, 39, 40, 42 - 44, 60, 63, 65, 68, 69) necessary for the microscope operation at increased pressure in the sample chamber forming one or more readily dismountable sub-assemblies in the sample chamber.

17. Scanning electron microscope according to one of the preceding claims, in which a magnetic field is present between the sample (11) and the lowest pressure stage aperture (18), which field, with respect to the optical axis, is rotationally symmetrical and improves the transport of the secondary electrons from the sample to the pressure stage aperture opening (16).

18. Scanning electron microscope according to one of the preceding claims, in which the secondary electrons on their way to the detector (51, 74, 91) go through at least two pressure stage aperture openings (16, 41), in which a magnetic field is present, such that all the magnetic field lines which extend through the lower pressure stage aperture opening (18) also extend through the upper pressure stage aperture opening (44).

19. Scanning electron microscope according to one of the preceding claims, in which, in addition to the magnetic field of the objective lens (62, 64), an additional magnetic field (80) is arranged, which directs the secondary electrons in the direction towards the detector (51).

20. Scanning electron microscope according to one of the preceding claims, in which a counterelectrode (78) is arranged in order to brake the secondary electrons and as a result to assist the transport of the secondary electrons towards the detector (51).

21. Scanning electron microscope according to one of the preceding claims, in which a detector is provided for energy dispersive X-ray spectroscopy (EDX) in order to operate at spacings of less than 1.5 mm between the sample (11) and the lowest pressure stage aperture (18).

22. Method for taking scanning electron microscopic images of a sample, with the steps:
- arrangement of the sample in a sample chamber at increased pressure,
- irradiation of the sample with a primary electron beam, which is generated with a beam generator, one or more pressure stage apertures and a magnetic lens for focusing the primary electron beam onto the sample being disposed between the beam generator and the sample,
- transport of secondary electrons through the at least one pressure stage aperture to a positively pre-biased detector (51, 74, 91) which is disposed on the beam generator side of the focusing magnetic field of the magnetic lens, the detector comprising a scintillator-photomultiplier combination, a semiconductor detector, a channel plate detector or a channeltron detector,
- signal multiplication in the detector or along the detector surface, a multiplicity of photons, electrons or electron hole pairs being generated from each secondary electron, and
- determination of the scanning electron microscopic image from the detector signal.

## Revendications

1. Microscope électronique à balayage comprenant un canon électronique et une chambre d'échantillon, entre lesquels est(sont) disposé(s) un ou plusieurs diaphragme(s) de palier atmosphérique, à travers les ouvertures duquel(desquels) un faisceau électronique primaire peut être dirigé sur un échantillon dans la chambre d'échantillon et comprenant une lentille magnétique, avec laquelle le faisceau électronique primaire sur l'échantillon peut être mis au point, le diaphragme de palier atmosphérique (18) le plus inférieur, le plus proche de l'échantillon, à travers lequel le faisceau électronique primaire touche l'échantillon, étant réglé pour isoler une pression plus élevée dans la chambre d'échantillon par rapport au reste de la colonne du microscope électronique à balayage et pour faire passer des électrons secondaires à travers son ouverture (16) depuis l'échantillon jusqu'à au moins un détecteur,
**caractérisé en ce que**
le détecteur est disposé côté canon électronique par le champ magnétique de la lentille magnétique effectuant la mise au point et est un détecteur polarisé de façon positive par rapport à l'échantillon et comprend une multiplication du signal, de telle sorte qu'une pluralité de photons, d'électrons ou de paires électron-trou est générée par chaque électron secondaire dans le détecteur, le détecteur comportant une combinaison de scintillateur et de photomultiplicateur, un détecteur semi-conducteur, un détecteur channelplate ou un détecteur channeltron.

2. Microscope électronique à balayage selon la revendication 1, dans lequel au moins une électrode (39, 43, 44, 55) est disposée au-dessus du diaphragme de palier atmosphérique le plus inférieur (18), laquelle électrode présente par rapport au diaphragme de palier atmosphérique (18) une tension positive et est réglée pour diriger les électrons secondaires de l'échantillon au détecteur (51, 74, 91).

3. Microscope électronique à balayage selon la revendication 1, qui est réglé pour détecter des électrons secondaires à travers l'ouverture d'au moins un diaphragme de palier atmosphérique, qui est constitué par couches d'au moins deux couches (39, 43) conductrices, isolées électriquement l'une de l'autre, les couches conductrices pouvant être alimentées en tensions, de telle sorte que le côté inférieur ou supérieur du diaphragme de palier atmosphérique respectif possède une tension aux électrodes.

4. Microscope électronique à balayage selon la revendication 2 ou 3, dans lequel le diaphragme de palier atmosphérique (18) et/ou les électrodes situées sur celui-ci (39, 43, 44, 50, 55) forment une ou plusieurs lentille(s) électrostatique(s) qui est(sont) réglée(s) pour faire la mise au point du faisceau électronique primaire dans le champ électrique entre le diaphragme de palier atmosphérique (18) et l'électrode située sur celui-ci (44 et/ou 39) et/ou entre les électrodes situées sur celui-ci (43, 44, 50, 55).

5. Microscope électronique à balayage selon la revendication 2 ou 3, dans lequel les électrodes (39, 43, 44, 50, 55) sont disposées de façon concentrique par rapport à l'axe optique du microscope électronique à balayage.

6. Microscope électronique à balayage selon l'une des revendications 2 à 5, dans lequel la surface du détecteur (51, 75, 91) présente au moins dans des plages partielles une tension qui est positive de plus de 500 V par rapport à la tension de l'échantillon.

7. Microscope électronique à balayage selon l'une des revendications 2 à 5, dans lequel la surface du détecteur (51, 75, 91) présente au moins dans des plages partielles une tension qui est positive de plus de 1000 V par rapport à la tension de l'échantillon.

8. Microscope électronique à balayage selon l'une des revendications 2 à 7, dans lequel est prévue une lentille d'objectif électrostatique et magnétique combinée.

9. Microscope électronique à balayage selon l'une des revendications 2 à 8, dans lequel une ou plusieurs électrode(s) (39, 44) forme(nt) au-dessus du diaphragme de palier atmosphérique (18) d'autres diaphragmes de palier atmosphérique, des systèmes de pompe destinés à générer des dépressions dans les espaces intermédiaires situés entre les diaphragmes de palier atmosphérique étant prévus.

10. Microscope électronique à balayage selon la revendication 9, dans lequel les électrodes configurées comme des diaphragmes de palier atmosphérique possèdent des ouvertures qui possèdent une dimension caractéristique inférieure à 1500 µm.

11. Microscope électronique à balayage selon l'une des revendications 2 à 10, dans lequel est prévue une structure constituante, les composants (13, 18, 19, 31, 32, 39, 40, 42 à 44, 60, 63, 65, 68, 69) nécessaires au fonctionnement du microscope dans le cas d'une pression plus élevée dans la chambre d'échantillon formant dans la chambre d'échantillon un ou plusieurs sous-groupe facilement démontable(s).

12. Microscope électronique à balayage selon la revendication 2, dans lequel un premier détecteur (74) est disposé avec son bord extérieur ou une ouverture intérieure (77) de manière adjacente au faisceau électronique primaire et un second détecteur (91) est prévu, qui est positionné par rapport à la direction de déplacement des électrons secondaires derrière le bord et/ou l'ouverture du premier détecteur (74) et réglé pour détecter des électrons secondaires (85, 86) qui se déplacent sur le bord en passant devant une ouverture (77) ou à travers celle-ci.

13. Microscope électronique à balayage selon l'une des revendications 2 à 12, dans lequel les électrons secondaires sont déviés de l'axe optique à l'aide d'un champ magnétique (80).

14. Microscope électronique à balayage selon la revendication 1, dans lequel la surface du détecteur (51, 75, 91) présente au moins dans des plages partielles une tension qui est positive de plus de 500 V par rapport à la tension de l'échantillon.

15. Microscope électronique à balayage selon la revendication 1, dans lequel la surface du détecteur (51, 75, 91) présente au moins dans des plages partielles une tension qui est positive de plus de 1000 V par rapport à la tension de l'échantillon.

16. Microscope électronique à balayage selon la revendication 1 ou 15, dans lequel est prévue une structure constituante, les composants (13, 18, 19, 26, 31, 32, 39, 40, 42 à 44, 60, 63, 65, 68, 69) à présent nécessaires au fonctionnement du microscope dans le cas d'une pression plus élevée dans la chambre d'échantillon formant dans la chambre d'échantillon un ou plusieurs sous-groupe facilement démontable(s).

17. Microscope électronique à balayage selon l'une quelconque des revendications précédentes, dans lequel est présent un champ magnétique entre l'échantillon (11) et le diaphragme de palier atmosphérique le plus inférieur (18), qui est à symétrie de révolution par rapport à l'axe optique et qui améliore le transport des électrons secondaires de l'échantillon à l'ouverture de diaphragme de palier atmosphérique (16).

18. Microscope électronique à balayage selon l'une quelconque des revendications précédentes, dans lequel les électrons secondaires cheminent en direction du détecteur (51, 74, 91) à travers au moins deux ouvertures de diaphragme de palier atmosphérique (16, 41), dans lesquelles est présent un champ magnétique de telle sorte que l'ensemble des lignes de force du champ magnétique, qui s'étendent à travers l'ouverture inférieure de diaphragme de palier atmosphérique (18), s'étend également à travers l'ouverture supérieure de diaphragme de palier atmosphérique (44).

19. Microscope électronique à balayage selon l'une quelconque des revendications précédentes, dans lequel est aménagé un champ magnétique additionnel (80) en plus du champ magnétique de la lentille d'objectif (62, 64), lequel champ magnétique dirige les électrons secondaires en direction du détecteur (51).

20. Microscope électronique à balayage selon l'une quelconque des revendications précédentes, dans lequel une contre-électrode (78) est réglée pour freiner les électrons secondaires et favoriser de ce fait le transport des électrons secondaires en direction du détecteur (51).

21. Microscope électronique à balayage selon l'une quelconque des revendications précédentes, dans lequel un détecteur est prévu pour une spectrométrie X à dispersion d'énergie (EDX) pour fonctionner sur des distances inférieures à 1,5 mm entre l'échantillon (11) et le diaphragme de palier atmosphérique le plus inférieur (18).

22. Procédé d'enregistrement d'images d'un échantillon prises par un microscope électronique à balayage, comprenant les étapes de :
- disposition de l'échantillon dans une chambre d'échantillon sous une pression plus élevée,
- irradiation de l'échantillon par un faisceau électronique primaire, qui est généré par un canon électronique, un ou plusieurs diaphragme(s) de palier atmosphérique et une lentille magnétique destinée à faire la mise au point du faisceau électronique primaire sur l'échantillon étant disposés entre le canon électronique et l'échantillon,
- transport des électrons secondaires à travers l'un des diaphragmes de palier atmosphérique en direction d'un détecteur (51, 74, 91) polarisé de façon positive, qui est disposé côté canon électronique par le champ magnétique de la lentille magnétique effectuant une mise au point, le détecteur comportant une combinaison de scintillateur et de photomultiplicateur, un détecteur de semi-conducteur, un détecteur de channelplate ou un détecteur de channeltron,
- multiplication du signal dans le détecteur ou le long de la surface du détecteur, une pluralité de photons, d'électrons ou de paires d'électron-trou étant générée par chaque électron secondaire, et
- détermination de l'image prise par le microscope électronique à balayage à partir du signal du détecteur.
